# EUROPEAN PATENT SPECIFICATION

(11) **EP 3 201 690 B1**
(45) Date of publication and mention of the grant of the patent: **18.12.2019**
(21) Application number: 15778164.2
(22) Date of filing: 29.09.2015
(51) Int. Cl.: G03F 1/00, B01L 3/00, B81B 1/00, G03F 7/00, G03F 7/033, G03F 7/11, G03F 7/32

(54) **A MICROFLUIDIC DEVICE AND A METHOD FOR PREPARING THE MICROFLUIDIC DEVICE FROM A PHOTOSENSITIVE ELEMENT**
MIKROFLUIDISCHE VORRICHTUNG UND VERFAHREN ZUR HERSTELLUNG DER MIKROFLUIDISCHEN VORRICHTUNG AUS EINEM LICHTEMPFINDLICHEN ELEMENT
DISPOSITIF MICRO-FLUIDIQUE ET SON PROCÉDÉ DE PRÉPARATION À PARTIR D'UN ÉLÉMENT PHOTOSENSIBLE

(30) Priority: 29.09.2014 US 201462056649 P
(43) Date of publication of application: 09.08.2017
(73) Proprietor: E. I. du Pont de Nemours and Company, Wilmington, DE 19805 (US)
(72) Inventor: CHISHOLM, Dexter A., Unionville, Pennsylvania 19375-9999 (US)
(74) Representative: Dehns
(86) International application number: PCT/US2015/052856
(87) International publication number: WO 2016/053986

(56) References cited:
- WO-A1-01/17797
- WO-A2-2005/030822
- WO-A2-2007/009125
- JP-A- 2007 098 347
- US-A1- 2002 123 134

## Description

### BACKGROUND OF THE INVENTION

### 1. Field of the Disclosure

This invention pertains to a microfluidic device and a method for making the microfluidic device, and in particular, to a microfluidic device prepared from a photosensitive composition by a direct imaging method.

### 2. Description of Related Art

The increasing sophistication of microfluidic devices has expanded the opportunity to use such devices in a growing number of applications. Microfluidics has developed into a useful technology that has found application in genome mapping, rapid separations, sensors, nanoscale reactions, ink-jet printing, drug delivery, Lab-on-a-Chip, in vitro diagnostics, injection nozzles, biological studies, and drug screening. Diagnostics for agriculture are a particular interest. Point of use diagnostics are an expanding use due to low cost, convenience, and time savings. Portable diagnostic devices can be used to detect proteins, nucleic acids, metabolites, drugs, animal cells and microbes. Samples can include bodily fluids, water, cell components, or food. Microfluidic devices offer a large opportunity for rapid point of use diagnostics for detection of human pathogens in food and detection of plant pathogens in crops. Detection can be based on any chemistry that can be pre-placed within features of the device during its fabrication, including for instance, the detection of pH, cell growth, antibiotic resistance, antibody binding, or molecular detection of nucleic acids.

A microfluidic device generally refers to a device through which materials, particularly fluid borne materials, such as liquids or gases, can be transported. A microfluidic device typically includes structural or functional features dimensioned on the order of a millimeter-scale or less, which are capable of manipulating a fluid at a flow rate on the order of a microliter/minute or less. Typically, such features include but are not limited to channels, fluid reservoirs, chambers, reaction chambers, mixing chambers, and separation regions. A microfluidic device can exist alone, or can be part of a microfluidic system which, for example and without limitation, can include: pumps for introducing fluids, e.g., samples, reagents, buffers, and the like, into the system and/or through the system; detection equipment or systems; data storage systems; and control systems for controlling fluid transport and/or direction within the device; monitoring and controlling environmental conditions to which fluids in the device are subjected, e.g. temperature, current and the like. In some end-use applications the microfluidic device is degassed under vacuum causing gas to dissolve out of a polymeric material forming the device. Upon exposure to air, gas dissolves back into the polymer (i.e., reabsorbs) creating a vacuum within the microfluidic device that drives fluid flow. These devices are also known as self-filling or degas driven flow, microfluidic devices.

Microfluidic devices developed in the early 1990s were fabricated from hard materials, such as silicon and glass, using photolithography and etching techniques. Photolithography and etching techniques, however, are costly and labor intensive, require clean-room conditions, and pose several disadvantages from a materials standpoint. As an alternative to hard materials, soft materials, i.e., elastomeric materials, emerged for use in microfluidic devices. The use of soft materials has made possible the manufacture and actuation of microfluidic devices containing valves, pumps, and mixers.

Poly(dimethylsiloxane) (PDMS) is one soft material that has been used for microfluidic device applications. PDMS material offers some attractive properties in microfluidic applications. Upon crosslinking, PDMS becomes an elastomeric material with a low Young's modulus, e.g., approximately 750 kPa, which allows PDMS to conform to surfaces and to form reversible seals. Also PDMS has a low surface energy, e.g., approximately 20 erg/cm², which can facilitate its release from molds after patterning. Another feature of PDMS is its gas permeability, which allows gas bubbles within the channels of a microfluidic device to permeate out of the device. This property also is useful in sustaining cells and microorganisms inside the features of the microfluidic device. However, PDMS suffers from a drawback in microfluidic application in that it swells in most organic solvents. Swelling of PDMS microfluidic device by organic solvents can disrupt its micron-scale features, e.g., a channel or plurality of channels, and can restrict or completely shut off the flow of organic solvent through the channels. An additional drawback is that the high water vapor permeability of PDMS results in drying of the aqueous reaction components when reactions are run at high temperatures, which causes reactions to fail. Thus, microfluidic applications with a PDMS-based device are limited to use of fluids that do not swell PDMS and by the temperature at which the reaction occurs.

DeSimone et al. in WO 2005/030822 disclose photocurable perfluoropolyether (PFPE) materials as another soft material that can be used to fabricate microfluidic devices. Photocurable PFPE material represent a unique class of fluoropolymers that are liquids at room temperature, exhibit low surface energy, low modulus, high gas permeability, and low toxicity with the added feature of being extremely chemically resistant.

Roy, E., et al. in "Thermoplastic Elastomers for Microfluidics: Towards a High-throughput Fabrication Method of Multilayered Microfluidic Devices." Lab on a Chip (2011): 11, 3193-3196, disclose the use of styrene-ethylene/butylene-styrene (SEBS) block copolymers as a thermoplastic elastomer (TPE) suitable as a potential substitute for PDMS in microfluidic devices. A multilayered microfluidic device was fabricated from extruded sheets of TPE that were embossed by molds formed of SU-8 under vacuum with an applied pressure at a temperature of 170°C. The embossed sheets of TPE were peeled from their respective molds, stacked to align, and bonded either with thermal treatment or at room temperature for two days. The fabrication method used for the TPE, as well as for PDMS and PFPE, involve a multistep process to form the mold or master in order to create the features of the microfluidic device.

Hosokawa, K., et al. in "Power-free Poly(dimethylsiloxane) Microfluidic Devices for Gold Nanoparticle-based DNA Analysis" Lap Chip, (2004) 4 181-185, disclose a power-free pumping method for PDMS microfluidic devices that utilizes the high gas solubility of the PDMS to degas the device under vacuum and thereby store energy for pumping for fluid transportation in the device by absorbing air when the device is brought back to the atmosphere.

US 2002/123134 describes a polmerizable film coating which can be used to make microfluidic chips. JP 207/098347 describes a polymerizable composition capable of forming a resinous microfluidic device. WO 2007/09125 and WO 01/17797 describe microfluidic devices.

However, microfluidic devices conventionally have been crafted by a two-stage process, called soft lithography, in which the soft material such as the PDMS or the PFPE, is a liquid that is cast on a mold or master that is fabricated from hard material. The soft material is thereupon cured, typically by blanket exposure to radiation, (but can be with heat), and removed from the mold to produce a solidified elastomeric microfluidic precursor that has a pattern of recessed microstructures, such as one or more channels and/or chambers that are suitable for use in a microfluidic device. The recessed pattern includes recesses that form the one or more channels and/or chambers of the microfluidic precursor.

The mold or master is a patterned substrate such as an etched silicon wafer or a photoresist patterned substrate, having a raised pattern that is opposite or the negative of the recessed pattern of microstructures formed in the solidified elastomeric microfluidic precursor. The process to form the mold with the negative raised pattern of microstructures on a substrate is also a multistep process. The mold substrate can be any smooth or substantially smooth metal, plastic, ceramic, glass, or silicon plane. Typically the raised pattern on the substrate is formed of a photoresist material, according to conventional methods that are well within the skill in the art. Plastic grating films and quartz grating films can also be used as masters. If very fine features on the order of nanometers are desired, masters can be formed on silicon wafers with e-beam radiation. The mold may be placed in a mold housing and/or with spacers along its perimeter to assist in the formation of a layer of the soft material.

The necessity to form a mold or master for the soft lithography process is time consuming and adds expense. It is also difficult to form by the soft lithography process a relatively large dimension (on the order of 12 by 12 in.) freestanding layer of elastomeric material having uniform thickness, which would include the microstructure pattern/s of one or more microfluidic precursors. As such, the process of using a mold in order to form the desired pattern of channels and chambers in the fabrication of one or more microfluidic devices is not suited to high volume production.

Furthermore, the soft lithography process limits the feature sizes of the channels and/or chambers that can be fabricated in the elastomeric material for the microfluidic device. The feature sizes attainable are limited to the depth of the photoresist layer on the mold, which results in channels and chambers of identical depth. It can be desirable for a single microfluidic device to be a diagnostic tool for multiple reagents or pathogens that require different reactive amounts. Thus it would be useful to be able to create microstructure features in a microfluidic device that have different sizes, i.e., depths and/or widths of channels or chambers. Control of the channel size allows control of flow rate and linear velocity of fluids within the device. Conventional soft lithography also does not facilitate smooth transitions in channel volume.

Thus it is desirable to form microfluidic devices from materials that avoid some or all of the drawbacks of PDMS. It is also desirable to avoid fabrication methods for microfluidic devices that require the fabrication of a master or mold or any molding operation, but yet can easily create different depths and/or widths of microstructures or features for the device.

### SUMMARY

It is an object of this invention to provide a method which may be used to form microfluidic devices that does not require the fabrication of a master or mold or any molding operation. It is desirable for the method to employ a direct imaging technique that can create microstructure/s in a material for use as a microfluidic device. A direct imaging technique does not require a mold to form the microstructures of the microfluidic device. The method should be economical and facilitate high-volume production of microfluidic devices.

It is another object of this invention to provide soft or elastomeric materials as alternatives to PDMS and PFPE that can be easily and directly formed into microfluidic devices. It is desirable that the soft or elastomeric materials form a precursor article that can be readily converted into a microfluidic device and that has the properties necessary to function as a microfluidic device, particularly microfluidic device that can operate under degas driven flow.

Yet another object of this invention is to provide a method that can easily prepare, without use of a mold or master, a microfluidic device having microstructures of channels and/or chambers that can be of different depths and/or widths.

Yet another object of this invention is to provide a method for high-volume fabrication of self-filling microfluidic devices.

In accordance with this invention there is provided a method for preparing a microfluidic device that includes a) providing a photosensitive element comprising a solid layer of a photopolymerizable composition comprising a binder, a monomer, and a photoinitiator; b) imagewise exposing the photopolymerizable layer to actinic radiation through a mask, forming at least a cured portion and an uncured portion of the layer; c) treating to remove the uncured portion from the layer and thereby form a precursor of the cured portion having an exterior surface and a relief pattern comprising at least one channel that is open to the exterior surface; and d) disposing a cover member above the exterior surface of the precursor to enclose the channel forming the microfluidic device, and e) degassing the precursor of the microfluid device of step d) by applying vacuum.

In accordance with another aspect of this invention there is provided photoimageable microfluidic device precursor element that includes a solid layer of a photopolymerizable composition comprising a binder, a monomer, and a photoinitiator, wherein the solid layer is selectively imageable and removable to form at least one channel for transporting a fluid therein. The photoimageable microfluidic device precursor further comprises a digitally imageable element layer having a digital layer disposed above the solid photopolymerizable layer.

In accordance with yet another aspect of this invention there is provided a microfluidic precursor that includes: a photocured layer of a solid layer of a photopolymerizable composition comprising at least a binder, a monomer, and a photoinitiator. The photocured layer has an exterior surface, and is a channel-bearing layer comprising at least one channel for transport of a fluid, and optionally at least one chamber that communicates with at least one channel, wherein the at least one channel and at least one chamber are open to the exterior surface. The microfluidic precursor further comprises a cover member disposed in contact with the exterior surface to enclose the at least one channel, wherein the cover member is selected from a photocured layer of a second photosensitive element comprising a solid layer of a photopolymerizable composition comprising a binder, a monomer, and a photoinitiator; or a cured layer of a polymeric material selected from polydimethylsiloxanes or perfluoropolyethers.

In accordance with another aspect of this invention there is provided a de-gas driven microfluidic device comprising a photocured layer of a first photosensitive element comprising a solid layer of photopolymerizable composition comprising a binder, a monomer, and a photoinitiator, the photocured layer having an exterior surface and is a channel-bearing layer comprising at least one channel for transport of a fluid, and optionally at least one chamber that communicates with at least one channel, wherein the at least one channel and the optional at least one chamber are open to the exterior surface; optionally, a diagnostic reagent disposed in the at least one chamber; and, a cover member disposed in contact with the exterior surface enclosing the at least one channel, and the at least one chamber if present; wherein the photocured layer is degassed.

Disclosed herein is a microfluidic device suitable for operation under degas driven flow that includes a photocured layer of a solid layer of a photopolymerizable composition comprising at least a binder, a monomer, and a photoinitiator. The photocured layer having an exterior surface and a channel-bearing layer comprising at least one channel for transport of a fluid, and optionally at least one chamber that communicates with at least one channel wherein the at least one channel and at least one chamber are open to the exterior surface. Optionally, a diagnostic reagent is disposed in the at least one chamber. The microfluidic device also includes a cover member disposed above the exterior surface enclosing the at least one channel and the at least one chamber; wherein the photocured layer is evacuated of air.

### BRIEF DESCRIPTION OF THE DRAWINGS

The invention can be more fully understood from the following detailed description thereof in connection with the accompanying drawing described as follows:
FIG. 1A through FIG. 1H are a schematic elevation views of one embodiment of a method of making a microfluidic device from one embodiment of a photosensitive element.
FIG. 1A is a schematic elevation view of one embodiment of the photosensitive element by one embodiment of a direct imaging method, the photosensitive element having a digital layer adjacent a layer of a photosensitive composition on a support.
FIG. 1B is a schematic elevation view of an optional step of the method of making the microfluidic device that includes exposing the photosensitive element of FIG. 1A to actinic radiation through the support.
FIG. 1C is a schematic elevation view of another step in the method of making the microfluidic device that includes imagewise exposing the digital layer of the photosensitive element of FIG. 1A to laser radiation to form an in-situ mask adjacent the photopolymerizable layer of the element.
FIG. 1D is a schematic elevation view of another step of the method of making the microfluidic device that includes imagewise exposing the photopolymerizable layer of the photosensitive element through the in-situ mask to actinic radiation to selectively expose and polymerize or cure portions of the photopolymerizable layer.
FIG. 1E is a schematic elevation view of another step of the method of making the microfluidic device that includes treating the photosensitive element to remove the in-situ mask and portions of the photopolymerizable layer that were not exposed (i.e., the unpolymerized or uncured portions) and form microfluidic precursor having a relief surface formed of the polymerized layer. The relief surface includes three recessed areas that are open and will form microstructures, such as chambers and/or channels, in the microfluidic device.
FIG. 1F is a schematic elevation view of an optional step of the method of making the microfluidic device that includes applying a diagnostic reagent to the open recessed areas of the microfluidic precursor.
FIG. 1G is a schematic elevation view of another step of the method of making the microfluidic device that includes applying an embodiment of a cover member to the relief surface of the precursor, thereby covering the microstructures that can be chambers and/or channels of the microfluidic precursor, wherein the cover member includes a polymerized layer adjacent to a support to form the microfluidic device.
Fig. 1H is a schematic elevation view of one embodiment of the microfluidic device that is prepared from the photosensitive element.
FIG. 2A is a planar perspective view of one embodiment of the cover member, wherein the cover member includes a polymerized or cured layer of a photosensitive composition adjacent to a support.
FIG. 2B is a perspective three-dimensional view of one embodiment of a microfluidic precursor showing microstructure of open recessed areas that form channels and chambers.
FIG. 2C is a planar cross-sectional view of one embodiment of a microfluidic device, wherein the view is taken along line 2C-2C of the precursor of FIG. 2B. In this embodiment, the microfluidic device is composed of the cover member shown in FIG. 2A attached to the microfluidic precursor of FIG. 2B, thereby sealing the open recessed areas that form channels and chambers.

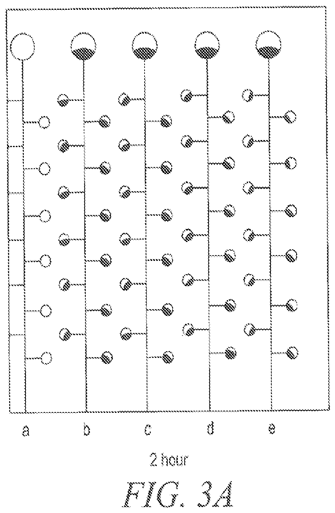

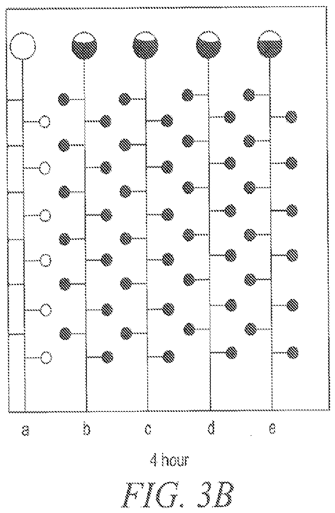

FIG. 3A and FIG. 3B are reproductions of digital images taken with a handheld digital camera with strong backlighting of an embodiment of a composite of a collection of microfluidic devices prepared according to one embodiment of a direct imaging method of the present invention as described in Example 1, showing degas-driven flow of a blue dye solution into a plurality of chambers of the microfluidic devices as function of chamber size and a function of time. A lower end of each of the microfluidic devices was immersed in a dye solution (not shown) as an analyte that has blue color in order to visualize the degas-driven flow into the chambers.
FIG. 3A is a planar view of a composite microfluidic device taken at about 2 hours after immersion in the blue dye solution, wherein the composite microfluidic device contains five independent microfluidic devices, which are designated a, b, c, d, and e, and where each independent microfluidic device has a different size main channel (and branch channels) but the same sizes for the large chamber and small chambers.
FIG. 3B is a planar view of the composite microfluidic device of FIG. 3A taken at about 4 hours after immersion in the blue dye solution. The designations a through e for the microfluidic devices that were described for FIG. 3A, are the same for FIG. 3B.

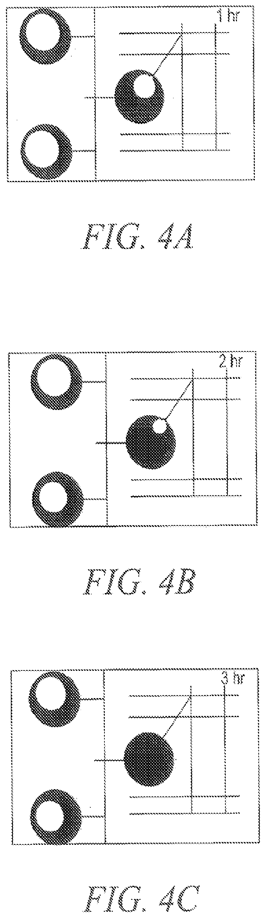

FIG. 4A through FIG. 4C are reproductions of digital images taken with a handheld digital camera of planar views of a segment of an embodiment of microfluidic devices prepared according to one embodiment of a direct imaging method of the present invention as described in Example 2, showing degas-driven flow of a dye solution into a plurality of chambers of the microfluidic devices as a function of time. The segment includes a main channel having three branch channels connecting each to a separate chamber. One of the three chambers is connected directly or indirectly to fill-enhancing ducts that are not connected to the main channel or to the branch channels. The main and branched channels are 60 micron wide, 30 micron deep; and, the chambers are 2000 micron wide (diameter) and 600 micron deep. The fill-enhancing ducts are 60 micron wide, 30 micron deep. A lower end of the microfluidic device was immersed in the dye solution (not shown) that is blue in color in order to visualize the degas-driven flow into the chambers. In each of FIG. 4A through 4C, the Control was the two chambers on the left-hand side of the channel where the two chambers were connected to the main channel but not connected to fill-enhancing ducts; and the chamber on the right-hand side of the channel was directly or indirectly connected to fill-enhancing ducts that were not connected to the fill channel or a branch channel.
FIG. 4A is a planar view of a segment of a microfluidic device at about an hour after immersion into the blue dye solution. The dark region in each of the chambers shows the fill of the solution into the chamber at one hour.
FIG. 4B is a planar view of the same segment of the microfluidic device of FIG. 4A at about two hours after immersion into the blue dye solution. The dark region in each of the chambers shows the fill of the solution into the chamber at two hours.
FIG. 4C is a planar view of the same segment of the microfluidic device of FIG. 4A at about three hours after immersion into the blue dye solution. The dark region in each of the chambers shows the fill of the solution into the chamber at three hours. The chamber connected to the fill-enhancing duct filled sooner than the other two chambers that were only connected to the main and branched channels.

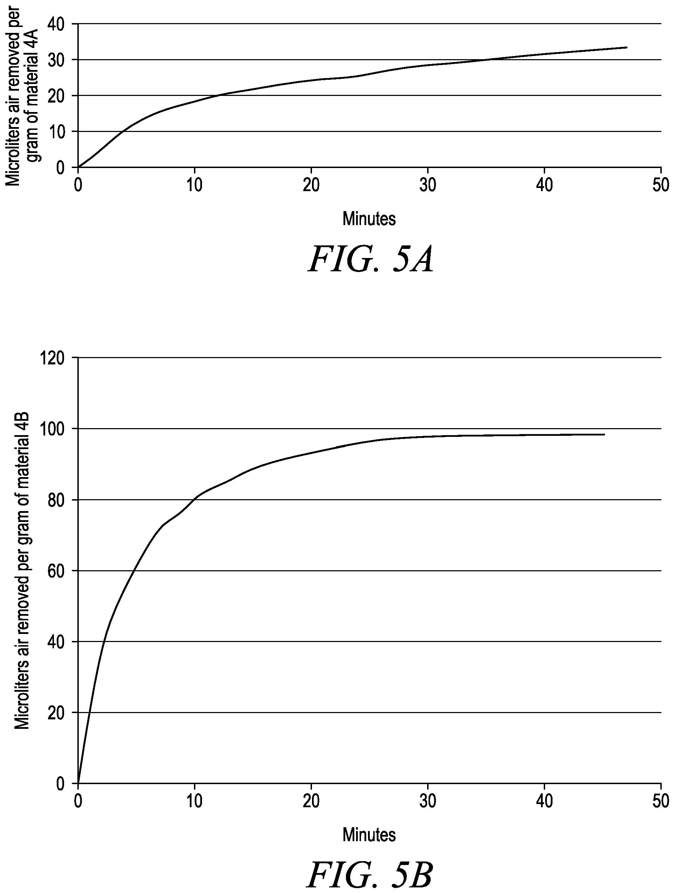

FIG. 5A is a graph of microliters of air removed per gram of material versus minutes which shows the rate of gas absorption capacity for a sheet of a solid photopolymerizable precursor that is designated as Material 4A as described in Example 4.
FIG. 5B is a graph s a graph of microliters of air removed per gram of material versus minutes which shows the rate of gas absorption capacity of a sheet of a polydimethylsiloxane material that is designated as Material 4B as described in Example 4.

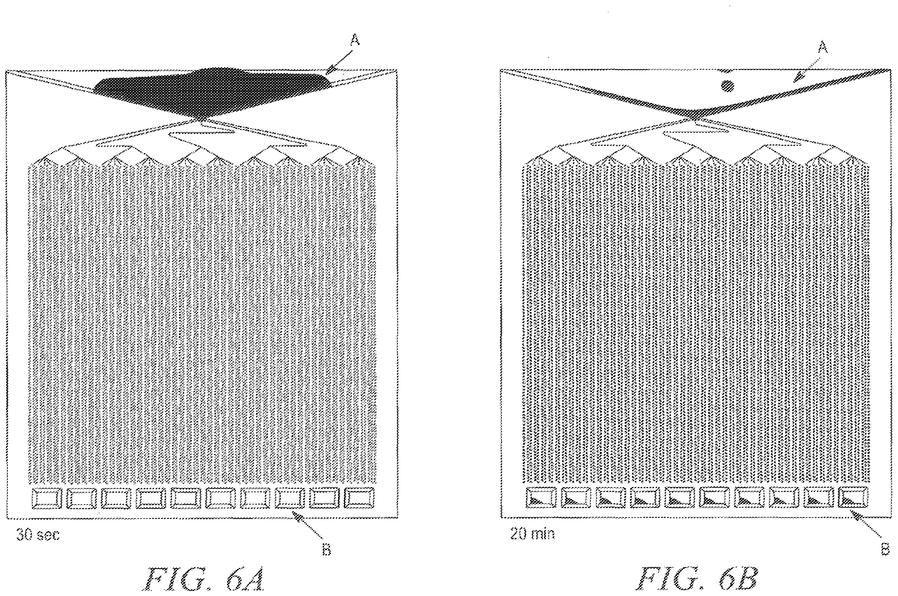

FIG. 6A and FIG. 6B are reproductions of digital images taken with a digital camera with strong backlighting of one embodiment of a hybrid microfluidic device having 10,000 wells that was prepared as described in Example 5, showing degas driven flow of 1 milliliter of a blue dye solution (to visualize filling) into the hybrid microfluidic device as a function of time. An end of the hybrid microfluidic device was filled with the dye solution from a 1.8 ml sample loading reservoir that is indicated with arrow A, and having overflow chambers for receiving excess sample that is indicated by arrow B. The digital image of FIG. 6A was taken 30 seconds after loading of the dye solution. The digital image of FIG. 6B was taken 20 minutes after loading the blue dye solution.

### DESCRIPTION OF THE PREFERRED EMBODIMENTS

Throughout the following detailed description, similar reference characters refer to similar elements in all figures of the drawings.

The present invention relates to a microfluidic device and a method for preparing the microfluidic device, and in particular, to a microfluidic device prepared from a photosensitive element. The microfluidic device that is prepared from the present photosensitive element is sufficiently gas, i.e., air, permeable to have particular use as a microfluidic device that operates by degas driven flow. The method employs direct imaging techniques and thereby avoids the complications and costs associated with the fabrication and use of a mold or master to create a microfluidic device. The method is economical and faster than a mold making process, and facilitates large volume production of microfluidic precursors and microfluidic devices. In some embodiments, because the photosensitive element includes a photopolymerizable layer that is a solid or self-supporting layer, the element can be pre-formed into plate-like structure that typically can have a size of 50 inch by 80 inch (127 cm by 203.2 cm) and can be larger. The large size allows for creating a plurality of microfluidic devices from just one plate-like structure, and thus can provide for an economical, high-volume method of fabricating microfluidic devices.

The method utilizes a photosensitive element that is directly imaged with actinic radiation through a mask to create a microfluidic precursor having a relief surface composed of microstructures suitable for transport of fluid borne materials. In most embodiments, the relief surface of microstructures forms at least one channel and at least one chamber in the converted microfluidic device. The relief surface may also be considered a photocured layer that is a channel-bearing layer composed of at least one channel and optionally at least one chamber. The present method enables control of the size of the microstructures formed in the range of about 10 to 500 micron. The present method can provide microstructures in which there is a gradual or smooth transition at the intersection of one microstructure feature to a contiguous adjacent microstructure feature, such as, for example, a channel to a chamber, which helps to preserve laminar flow of a test fluid into the microfluidic device. Laminar flow in microfluidic devices allows for the transport of adjacent flow streams without mixing and without forming eddies or dead zones of fluid. Microfluidic devices prepared from photosensitive elements of the present invention can provide some of the same advantages of the soft elastomeric materials conventionally used in microfluidic devices, such as the ability to create fluid control features such as channels and chambers with a resolution as small as about 10 microns, with similar or comparable mechanical strength that provides stability of the material during fabrication and use of the microfluidic devices. Microfluidic devices prepared from the present photosensitive elements can also have the same or similar degas and reabsorption speed and capacity, i.e., gas-permeability, as that of materials conventionally used for microfluidic devices.

Microfluidic devices that are prepared from the photosensitive elements of the present invention are particularly useful in point-of-use microfluidic applications in which a test material flows by degas driven flow through the microstructure features that are formed in the device. Unlike conventional microfluidic devices prepared with liquid soft material from a master, the microfluidic precursors and the microfluidic devices of the present invention include a relief surface of microstructures that can have different depths and/or different widths. The ability to form microstructures of different depths and/or widths enables greater versatility for testing of different materials, at different concentrations, facilitates controlling the volume of the channel/s, and allows for the formation of constriction zones to control flow rate and linear velocity of fluids in the same microfluidic device. In some embodiments the precursor, and thus the microfluidic device, includes as part of the microstructure features one or more ducts that are directly or indirectly in communication with a chamber, but not connected to a channel, that enable quick fill of the chamber, i.e., fill-enhancing ducts. The fill-enhancing ducts increase the surface area exposed to the degassed polymer thereby accelerating reabsorption of gas.

"Photosensitive element" or "photosensitive precursor" refers to raw or uncured or blank, i.e., unexposed, forms having at least a layer of a photosensitive composition, with or without support, and/or any additional layers. In most embodiments, the photosensitive composition is a photopolymerizable composition. A photosensitive element for use as a microfluidic device may also be referred to herein as a photoimageable microfluidic device precursor element.

In addition to referring to forms in which the at least one layer of the photopolymerizable composition is entirely raw or uncured (i.e., unexposed), the "photosensitive element" or "photosensitive precursor" can also refer to forms in which the layer of the photopolymerizable composition is partially cured, i.e., includes cured portions which are polymerized and uncured portions which are not polymerized. The cured portions may be created by for instance, blanket exposing the element to actinic radiation at an energy density that polymerizes or cures a portion of the layer, but not the entire thickness of the layer; and/or, imagewise exposing the element to actinic radiation through a mask at an energy density that polymerizes or cures areas of the photopolymerizable layer corresponding to areas of the mask that are transparent to actinic radiation.

The term "curing" refers to hardening of a polymer material by crosslinking of polymer chains, brought about by chemical additives, heat, actinic radiation, or electron beam. Hardening occurs primarily by crosslinking of the polymer chains. But other interactions in the polymer material or resin, such as branching and linear chain extension, may also occur in relatively small degree compared to crosslinking of the polymer chains.

The term "photopolymerizable" is intended to encompass systems that are photopolymerizable, photocrosslinkable, or both. In cases where the composition layer comprises more than one photopolymerizable layer, the composition of each of the photopolymerizable layers can be the same or different from any of the other photopolymerizable layers.

The term "radiation", "irradiation" or "actinic radiation" means radiation that causes, typically in the presence of a photoinitiator, polymerization of monomers and/or oligomers that have ethylenically unsaturated double bonds, such as acrylic or methacrylic double bonds. Actinic radiation can include ultraviolet radiation, visible light, and e-beam radiation. Sources of actinic radiation may be natural sunlight or artificial radiation sources. Examples of ultraviolet radiation as actinic radiation include, but is not limited to, UV-A radiation, which falls within the wavelength range of from 320 nanometers (nm) to 400 nm; UV-B radiation, which is radiation having a wavelength falling in the range of from 280 nm to 320 nm; UV-C radiation, which is radiation having a wavelength falling in the range of from 100 nm to 280 nm; and UV-V radiation, which is radiation having a wavelength falling in the range of from 400 nm to 800 nm.

"Microfluidic precursor" or "microfluidic device precursor" refers to forms having the layer of polymerizable material that is cured or substantially cured (i.e., polymerized or substantially polymerized), and has a relief structure of at least one recessed feature that will be suitable for use in a microfluidic device. The relief structure may also be referred to herein as microstructure/s or features that are suitable for operation of a microfluidic device, such as, for example, at least one channel, at least one channel and at least one chamber, but is not limited to microstructures that are a chamber and/or channel. In most embodiments, the microfluidic precursor does not include a cover member, such that the relief structure, i.e. microstructure features, e.g., chamber/s and/or channel/s, of the microfluidic precursor is open or uncovered. In some other embodiments, the microfluidic precursor can include a cover member that covers at least one microfeature, for example a channel, but is not sealed or forms an incomplete seal.

The term "microfluidic device" generally refers to a device through which materials, particularly fluid borne materials, such as liquids or gases, can be transported. "Microfluidic device" refers to forms created from the cured or substantially cured layer of polymerized material having a relief structure of at least one microstructure that is useful in the microfluidic device, such as, for example, at least one chamber and at least one channel, that are enclosed or covered, and optionally wherein the at least one chamber includes a test material for the device.

A microfluidic device typically includes structural or functional features dimensioned on the order of a millimeter-scaled or less, which are capable of manipulating a fluid at a flow rate on the order of a microliter/minute or less. Typically, such features include, but are not limited to, channels, fluid reservoirs, chambers, reaction chambers, mixing chambers, and separation regions, fluid-fill enhancing ducts. In some examples, the channels include at least one cross-sectional dimension that is about 0.1 micrometer to about 500 micrometer. The use of dimensions on this order allows the incorporation of a greater number of channels in a smaller area, and utilizes smaller volumes of fluids. In most embodiments, the microfluidic device utilizes degas-driven flow to cause an analyte to transport in at least one channel to one or more chambers.

A microfluidic device can exist alone, or can be part of a microfluidic system which, for example and without limitation, can include: pumps for introducing fluids, e.g., samples, reagents, buffers, and the like, into the system and/or through the system; detection equipment or systems; data storage systems; and control systems for controlling fluid transport and/or direction within the device; monitoring and controlling environmental conditions to which fluids in the device are subjected, e.g. temperature, current and the like. The terms "channel" and "microfluidic channel" are used interchangeably and can mean a recess or cavity formed in a material by imparting a pattern according to the present method. In an alternate embodiment the terms "channel" and "microfluidic channel" are used interchangeably and can mean a recess or cavity in combination with any suitable fluid-conducting structure mounted in the recess or cavity, such as a tube, capillary, or the like.

The terms "flow channel" and "control channel" are used interchangeably and can mean a channel in a microfluidic device in which a material, such as a fluid, e.g., a gas or a liquid, can flow through. More particularly, the term "flow channel" refers to a channel in which a material of interest, that can be referred to as an analyte, e.g., a solvent or a chemical reagent, can flow through. The term "control channel" refers to a flow channel in which a material, such as a fluid, e.g., a gas or a liquid, can flow through in such a way to actuate a valve or a pump.

The terms "fluid-fill enhancing duct" or "fill-enhancing duct", or simply "duct", refers to a recessed path or pattern of paths formed in the polymerized layer of the microfluidic device that is connected directly or indirectly (through one or more other duct/s) to a chamber, but recessed path is not connected directly to a channel or flow channel in the device. Thus, the fluid-fill enhancing ducts are not channels in which a fluid or analyte transports or to flow through to a chamber/s, but serve to provide additional path for gas removal by degas drive flow from the microfluidic device.

The term "pattern" refers to the relief structure of at least a recessed feature that will be suitable for use in the microfluidic device. A pattern can mean a channel or a flow channel or an integrated network of channels or flow channels which, in some embodiments, can intersect at predetermined points. A pattern also can comprise one or more of recessed features such as a microscale fluid reservoir; a microscale chamber, which can be a reaction chamber or a mixing chamber; a microscale separation region, and ducts. A pattern can also refer to the fill-enhancing duct or ducts as described above.

The term "intersect" can mean to meet at a point, to meet at a point and cut through or across, or to meet at a point and overlap.

The term "communicate" (e.g., a first component "communicates with" or "is in communication with" a second component) and grammatical variations thereof are used to indicate a structural, functional, mechanical, electrical, optical or fluidic relationship, or any combinations thereof, between two or components or elements. As such, the fact that one component is said to communicate with a second component is not intended to exclude the possibility that additional components can be present between, and /or operatively associated or engaged with, the first and second components.

The term "constriction zones" can mean a region of the device wherein fluid flow is restricted by reducing the cross-sectional area of a channel.

"Degas-driven flow" is a phenomenon that propels fluid, i.e., gas or liquid, in microfluidic devices prepared according to the claimed method of the present invention via the microfeature/s of the device without requiring external power, by taking advantage of the porosity and air solubility of the cured layer of the polymer composition by removing air molecules from the layer before initiating flow. Degas-driven flow transports the fluid by an induced vacuum that is created by gas molecules repartitioning into a suitably degassed polymer. "Degassing" is the removal or substantial removal of air or gas from the polymeric material that forms the microfluidic device.

The term "diagnostic reagent", or simply "reagent" refers to compounds used in a chemical assay or a biological assay, and thus may also be referred to as "assay reagent". Suitable reagents may be, for example, proteins, nucleic acids, cell extracts, organic molecules, antibiotics, antibodies, viruses, sugars, enzymes, enzyme inhibitors, pH indicators, substrates, catalysts, dyes chromophores, fluorochromes, buffers, and combinations thereof. Suitable proteins may include, for example, amino acids, peptides, peptide-nucleic acid conjugates, polypeptides, protein fragments, full-length proteins, recombinant proteins, synthesized proteins, and combinations thereof. Suitable proteins may include, for example, monoclonal antibodies, polyclonal antibodies, or antibody fragments. Particularly suitable are reagents that produce an optically detectable signal such as a change in color or optical density.

The term "analyte" refers to a fluid material, i.e., liquid or gas, that is the subject of analysis with the microfluidic device.

The term "room temperature" or, equivalently "ambient temperature," has its ordinary meaning as known to those skilled in the art and may include temperatures within the range of about 16°C (60°F) to about 32°C (90°F).

Unless otherwise indicated, all percentages of components in a composition are by weight based upon the total of the components in the composition.

### Photosensitive Element

The photosensitive elements of this invention are useful in forming microfluidic precursors which are converted to microfluidic devices with at least the addition of a cover member. In one embodiment, the photosensitive element includes at least a layer of a photopolymerizable composition that forms a self-supporting layer (i.e., solid layer) prior to cure or photopolymerization. The layer of the photosensitive composition is sensitive to actinic radiation. In most embodiments, the photosensitive element includes a layer of a photopolymerizable composition comprising a binder, at least one ethylenically unsaturated compound, and photoinitiator. In most embodiments, the binder is a polymer that functions to impart desired physical and chemical characteristics to the exposed and unexposed photopolymerizable composition. In some embodiments, the binder is an elastomeric binder. In most embodiments, the layer of photopolymerizable composition is elastomeric. In one embodiment, the photosensitive element can be of a bi- or multi- layer construction. In other embodiments, the photosensitive element includes a support adjacent to the layer of the photosensitive composition. In most embodiments, the photosensitive element includes a layer of the photopolymerizable composition interposed between a support and a temporary coversheet. In one embodiment the self-supporting layer, which may also be referred to as a solid layer, of the photopolymerizable composition can be imagewise exposed and treated, i.e., selectively imageable and removable, to form a relief surface suitable for use as a microfluidic device, i.e., to form a channel-bearing layer for transport of a fluid.

As used herein, the term "solid" refers to the physical state of the layer that has a definite volume and shape and resists forces that tend to alter its volume or shape, beyond its elastomeric nature. The layer of the photopolymerizable composition is solid at room temperature. In most embodiments, the layer of the photopolymerizable composition is an elastomeric layer that is capable of resuming its original shape upon removal of a deforming force. A solid layer of the photopolymerizable composition may be polymerized (photohardened or cured), or unpolymerized, or both.

The photosensitive composition contains a polymer that may be referred to as a binder in addition to the one or more photoactive components. The polymer may be photoactive itself or may act as a matrix for the one or more photoactive components. The polymer is typically, but not necessarily, preformed. The polymer is not limited and includes polymers that are linear, branched, radial, comb, and can become interpenetrating networks. Other components in the composition should be compatible with the binder to the extent that a clear, non-cloudy photosensitive layer is produced.

The photopolymerizable composition can include a binder that is a preformed polymer that serves as a matrix for the monomer and photoinitiator system prior to exposure. The binder is a major contributor to the physical properties of the photopolymer, both before and after exposure. Addition of the binder allows the photosensitive element to be manufactured and handled as a dry film. Molecular weight, glass transition temperature, flexibility, chemical resistance, solubility, toughness, and tensile strength, as well as cost and availability are among the factors that govern binder selection. The binder should be of sufficient molecular weight and have sufficiently high glass transition temperature that a film, i.e., a self-supporting layer, is formed when the composition is coated. Suitable binders can have widely varying molecular weights, from as low as 25,000 to greater than 300,000, to as much as 1,200,000 have been described and can be used. Unless otherwise indicated the molecular weight of the polymeric binder is a mean molecular weight Mw determined with the aid of gel permeation chromatography using polystyrene standards. In general, the polymeric binder has a glass transition temperature not above 20°C.

The binder can be a single polymer or mixture of polymers. The binder can be thermoplastic, elastomeric, or a thermoplastic elastomer. Binders include natural or synthetic polymers of conjugated diolefin hydrocarbons, including polyisoprene, 1,2-polybutadiene, and 1,4-polybutadiene; block copolymers comprising a non-elastomeric block of vinyl polymer and an elastomeric block of a conjugated diene; nitrile elastomers; polybutylene elastomers; polyalkyleneoxides; elastomeric polymers and copolymers of acrylates and methacrylates; elastomeric polyurethanes; elastomeric polyesters; elastomeric polymers and copolymers of ethylene-propylene; elastomeric polymers of ethylene-propylene-diene; and, elastomeric copolymers of vinyl acetate and its partially hydrogenated derivatives; and combinations thereof.

In one embodiment, the thermoplastic binder is an elastomeric block copolymer of an A-B-A type block copolymer, where A represents a non-elastomeric block, preferably a vinyl polymer and most preferably polystyrene, and B represents an elastomeric block, such as, polybutadiene, polyisoprene, polyethylene-butylene. The block copolymers can be linear block copolymers, branched block copolymers, radial block copolymers, or quasi-radial block copolymers. The block copolymers can be hydrogenated block copolymers. The block copolymers are usually three-block copolymers of the A-B-A type, but can also be two block copolymers of the A-B type or those comprising a plurality of alternating elastomeric and thermoplastic blocks, for example A-B-A-B-A. Copolymers of butadiene and styrene, copolymers of isoprene and styrene, styrene-diene-styrene triblock copolymers, etc. are described in U.S. Patent Nos. 4,323,636, 4,430,417, and 4,045,231. The non-elastomeric block to elastomeric block ratio is preferably in the range of from 10:90 to 35:65. Some embodiments of the photosensitive element include block copolymers useful as thermoplastic elastomeric binders that poly(styrene/isoprene/styrene) (SIS) block copolymers, poly (styrene/butadiene /styrene) (SBS) block copolymers, and poly(styrene/isoprene-butadiene/styrene) (SIBS) block copolymers. In some other embodiments, block copolymers of poly(styrene-ethylene butylene-styrene) (SEBS) and block copolymers of poly(styrene-ethylene propylene-styrene) (SEPS) are also suitable as thermoplastic elastomeric binders.

Other binders suitable for use in the photopolymerizable composition include block copolymers that are chemically modified with either fluoroalkyl groups or fluoroalkyl side chains or hydroxyl side groups. The modified block copolymers with fluoroalkyl groups or fluoroalkyl side chains will provide the layer formed from the composition with hydrophobicity. The modified block copolymers with hydroxyl side groups will provide the layer formed from the composition with hydrophilicity. Any of the block copolymers described above can be modified to have the fluoroalkyl groups or side chains or the hydroxyl side groups. The olefinic double bonds present within the elastomeric block, such as butadiene or isoprene segments, serve as convenient sites for chemical modification. One method of preparing chemically modified block copolymers is disclosed by Antonietti et al., "Novel fluorinated block copolymers for the construction of ultra-low energy surfaces and as dispersion stabilizers in solvents with low cohesion energy", Acta Polymer, vol. 48, pp. 262-268, 1997, VCH Verlagsgesellschaft mbH. In addition to poly(styrene-butadiene-styrene) and poly(styrene-isoprene-styrene) elastomers as one embodiment of suitable chemically modifiable block copolymers, other chemically modifiable elastomeric polymers and rubbers can also be used in the photopolymerizable composition including various copolymers of butadiene with acrylonitrile and some neoprene rubbers. Chemically-modified block copolymers useful as a binder in a photopolymerizable composition are disclosed in U.S. Patents 8,541,162; U.S. 8,563,220; and, U.S. 8,715,906.

Elastomeric binders also encompass core-shell microgels and blends of microgels and preformed macromolecular polymers, such as those disclosed in U.S. Patent 4,956,252 and U.S. Patent 5,707,773.

In the case where aqueous washout or development of the photosensitive composition is desirable, other suitable binders include a branched polymer product and/or a modified binder that should contain sufficient acidic and/or other groups to render the composition processable in aqueous solution. Useful aqueous-processable binders include those disclosed in U.S. Patents 3,458,311; U.S. 4,273,857; U.S. 6,210,854; U.S. 5,679,485; U.S. 6,025,098; U.S. 5,830,621; U.S. 5,863,704; and U.S. 5,889,116. Useful amphoteric polymers include interpolymers derived from N-alkylacrylamides or methacrylamides, acidic film- forming comonomer and an alkyl or hydroxyalkyl acrylate such as those disclosed in U.S. Patent 4,293,635.

The binder is present between and optionally including any two of the following values: 45, 50, 55, 60, 65, 70, 75, 80, 85, 90, 95 wt%, based on the combined weight of the components of the composition. In one embodiment, the binder is present in an amount of at least about 45% to about 95% by weight of the photopolymerizable composition for photosensitive elements useful as microfluidic devices. In another embodiment, the binder is present at about 55% to about 95% by weight, and in yet another embodiment the binder is present at about 55% to about 90% by weight.

Other suitable photosensitive elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete description of some of these materials see U.S. Patent 5,015,556.

The photopolymerizable composition may contain a second polymeric binder to modify adhesion, flexibility, hardness, oxygen permeability, moisture sensitivity, compatibility with washout solution, and other mechanical or chemical properties required during its processing or end use. A suitable second binder includes non-crosslinked polybutadiene and polyisoprene; nitrile elastomers; polyisobutylene and other butyl elastomers; polyalkyleneoxides; polyphosphazenes; elastomeric polymers of acrylates and methacrylates; elastomeric copolymers of acrylates and methacrylates; elastomeric polyurethanes; elastomeric polyesters; elastomeric polymers and copolymers of olefins such as, ethylene-propylene copolymers, ethylene-propylene-diene, and non-crosslinked ethylene-propylene-diene monomers; elastomeric copolymers of vinyl acetate and its partially hydrogenated derivatives. Other suitable polymeric binders that can be used in combination include: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; polystyrene polymers and copolymers, e.g., with maleic anhydride and esters; vinylidene chloride copolymers, e.g., vinylidene chloride/acrylonitrile; vinylidene chloride/ methacrylate and vinylidene chloride/vinyl acetate copolymers; polyvinyl chloride and copolymers, e.g., poly(vinyl chloride/vinyl acetate); polyvinyl pyrrolidone and copolymers, e.g., poly(vinyl pyrrolidone/vinyl acetate) synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, high molecular weight polyethylene oxides of polyglycols having average molecular weights from about 4,000 to 1,000,000. Generally, the second polymeric binder can be present in an amount that is less than the primary binder, and between and optionally including any two of the following values 1, 5, 10, 15, 20, 25, 30, 35, 40, 45, 50 wt% based on the combined weight of the components in the composition.

The photopolymerizable composition includes at least one ethylenically unsaturated compound, that may also be referred to as a a monomeric material or a monomer, capable of forming a high polymer by photoinitiated polymerization. Typically the at least one ethylenically unsaturated compound is nongaseous and has a boiling point above 100°C at normal atmospheric pressure. Monomers that can be used in the composition activated by actinic radiation are well known in the art, and include, but are not limited to, addition-polymerization ethylenically unsaturated compounds having relatively low molecular weights that is, molecular weights generally less than about 30,000, and preferably less than about 5000. Unless described otherwise in the specification, the molecular weight is the weighted average molecular weight. The addition polymerization compound may also be an oligomer, and can be a single or a mixture of oligomers. If a polyacryloyl oligomer is used, the oligomer should preferably have a molecular weight greater than 1000. The composition can contain a single monomer or a combination of monomers. The monomer compound capable of addition polymerization is present between and optionally including any two of the following values: 5, 8, 10, 12, 15, 18, 20, 22, and 25 wt%, based on the combined weight of the components of the composition. In one embodiment the monomer/s is present at about 5% to about 25% by weight of the composition. In another embodiment, the monomer/s is present at about 6% to about 20% by weight of the composition.

Suitable monomers include, but are not limited to, acrylate monoesters of alcohols and polyols; acrylate polyesters of alcohols and polyols; methacrylate monoesters of alcohols and polyols; and methacrylate polyesters of alcohols and polyols; where the alcohols and the polyols suitable include alkanols, alkylene glycols, trimethylol propane, ethoxylated trimethylol propane, pentaerythritol, and polyacrylol oligomers. A combination of monofunctional and multifunctional acrylates or methacrylates may be used. In one embodiment the photopolymerizable compositions contain monofunctional or polyfunctional acrylates or methacrylates, and particularly preferred are such compositions containing monomers with two, three or more acrylate or methacrylate groups to allow concurrent crosslinking during the photopolymerization process. Other suitable monomers include acrylate derivatives and methacrylate derivatives of isocyanates, esters, epoxides, and the like. Other suitable monomers include alkylene or a polyalkylene glycol diacrylate prepared from an alkylene glycol of 2 to 15 carbons or a polyalkylene ether glycol of 1 to 10 ether linkages. Still other suitable monomers are fluorinated monomers that include fluorinated acrylates and fluorinated methacrylates. Some examples of fluorinated acrylates and fluorinated methacrylates are disclosed in U.S. Patent 8,541,162; U.S. 8,563,220; and, U.S. 8,715,906.

Further examples of suitable monomers include, but are not limited to the following: t-butyl acrylate, hexanediol diacrylate, hexanediol dimethacrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3- propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, 2,2-di(p-hydroxyphenyl)-propane diacrylate, pentaerythritol tetraacrylate, 2,2-di-(p-hydroxyphenyl)- propane dimethacrylate, triethylene glycol diacrylate, polyoxyethyl-2,2-di-(p-hydroxyphenyl)-propane dimethacrylate, di-(3-methacryloxy-2-hydroxypropyl)ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2- hydroxypropyl) ether of tetrabromo-bisphenol-A, di-(2- methacryloxyethyl) ether of tetrabromo-bisphenol-A, di- (3-methacryloxy-2-hydroxypropyl) ether of 1,4- butanediol, di-(3-methacryloxy-2-hydroxypropyl) ether of diphenolic acid, triethylene glycol dimethacrylate, polyoxypropyl one trimethylol propane triacrylate (462), ethylene glycol dimethacrylate, butylene glycol dimethacrylate, 1,3-propanediol dimethacrylate, 1,2,4- butanetriol trimethacrylate, 2,2,4-trimethyl-1,3- pentanediol dimethacrylate, pentaerythritol trimethacrylate, I-phenyl ethylene-1,2-dimethacrylate, pentaerythritol tetramethacrylate, trimethylol propane trimethacrylate, 1,5-pentanediol dimethacrylate, diallyl fumarate, 1,4-benzenediol dimethacrylate, 1,4- diisopropenyl benzene, and 1,3,5-triisopropenyl benzene.

In some embodiments, it may be desirable to use monomer that provides elastomeric properties to the photosensitive element. Examples of elastomeric monomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than about 20% by weight).

Upon exposure to actinic radiation, the photoinitiator or photoinitiator system induces chain propagated polymerization of the monomeric material by either a condensation mechanism or by free radical addition polymerization. While all photopolymerizable mechanisms are contemplated, the compositions and processes of this invention will be described in the context of free radical initiated addition polymerization of monomers having one or more terminal ethylenically unsaturated groups. In this context, the photoinitiator system when exposed to actinic radiation acts as a source of free radicals needed to initiate polymerization of the monomer. The photoinitiator of the system may be activated by a photosensitizer which absorbs actinic radiation which may be outside the absorption spectrum of the initiator itself, to sensitize the addition polymerization in more practical radiation spectral regions such as near ultraviolet, visible light and near infrared. In the narrow sense, the term photoactive component of the compositions of this invention refers to the material which absorbs the actinic radiation, e.g., the photoinitiator or the photosensitizer, but in the broader sense the term photoactive component refers to any or all the essential materials needed for photopolymerization, i.e., the photoinitiating system and the monomer.

The photoinitiator can be any single compound or combination of compounds (that is, a photoinitiator system) which is sensitive to actinic radiation, generating free radicals which initiate the polymerization of the monomer or monomers without excessive termination. The photoinitiator system has one or more compounds that directly furnish free-radicals when activated by actinic radiation. The system also may contain a sensitizer that is activated by the actinic radiation, causing the compound to furnish the free-radicals. Useful photoinitiator systems typically will contain a sensitizer that extends spectral response into the near ultraviolet, visible, and near infrared spectral regions. The term photoinitiator encompasses photoinitiator systems. Preferably, the photoinitiator is sensitive to actinic radiation in the ultraviolet and/or visible wavelengths of radiation. Photoinitiators are generally present in amounts from 0.001% to 10.0% based on the weight of the photopolymerizable composition.

Any of the known classes of photoinitiators, particularly free radical photoinitiators such as quinones, benzophenones, benzoin ethers, aryl ketones, peroxides, biimidazoles, benzyl dimethyl ketal, hydroxyl alkyl phenyl acetophone, dialkoxy acetophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, sulfonyl ketones, benzoyl oxime esters, thioxanthrones, camphorquinones, ketocouumarins, and Michler's ketone may be used.

Sensitizers useful with photoinitiators include methylene blue and those disclosed in U.S. Patents 3,554,753; 3,563,750; 3,563,751; 3,647,467; 3,652,275; 4,162,162; 4,268,667; 4,351,893; 4,454,218; 4,535,052; and 4,565,769. A preferred group of sensitizers include the bis(p-dialkylaminobenzylidene) ketones disclosed in Baum et al. U.S. Patent 3,652,275, and the arylyidene aryl ketones disclosed in Dueber U.S. Patent 4,162,162. In one embodiment suitable sensitizers include the following: DBC, i.e., cyclopentanone; 2,5-bis-{[4-(diethylamino)-2-methylphenyll-methylenel;
DEAW, i.e., cyclopentanone, 2,5-bisf[4-(diethylamino)-phenyllmethylenel;
dimethoxy-JDI, i.e., IH-inden-I-one, 2,3-dihydro-5,6-dimethoxy-2-[(2,3,6,7-tetrahydro-IH,5H-benzo[i,j]-quinolizin-9-yl)methylene)-; and JAW, i.e., cyclopentanone, 2,5-bis[(2,3,6,7-tetrahydro-IH,5H-benzo[i,j]quinolizin-1-yl)methylene]. Other particularly useful sensitizers are cyclopentanone, 2,5-bis[2-(1,3-dihydro-1,3,3-trimethyl-2H-indol-2-ylidene) ethylidene], CAS 27713-85-5; and cyclopentanone, 2,5-bis[2-(I-ethylnaphtho[1,2-d]thiazol-2(IH)-ylidene)ethylidenel.

Hydrogen donor compounds that function as chain transfer agents in the photopolymerizable compositions include: 2-mercaptobenzoxazole, 2-mercaptobenzothiazole, 4-methyl-4H-1,2,4-triazole-3-thiol, etc.; as well as various types of compounds, e.g., (a) ethers, (b) esters, (c) alcohols, (d) compounds containing allylic or benzylic hydrogen, (e) acetals, (f) aldehydes, and (g) amides disclosed in column 12, lines 18 to 58 of MacLachlan U.S. Patent 3,390,996. Suitable hydrogen donor compounds for use in systems containing both biimidazole type initiator and N-vinyl carbazole are 5- chloro-2-mercaptobenzothiazole; 2-mercaptobenzothiazole; 1H-Ir2,4-triazole-3-thiol; 6-ethoxy-2-mercaptobenzothiazole; 4-methyl-4H-1,2,4-triazole-3-thiol; 1-dodecanethiol; and mixtures thereof.

A particularly preferred class of photoinitiators and photosensitizers are benzophenone, Michler's ketone, ethyl Michler's ketone, p-dialkylaminobenzaldehydes, p- dialkylaminobenzoate alkyl esters, polynuclear quinones, thioxanthones, hexaarylbiimidazoles, cyclohexadienones, benzoin, benzoin dialkyl ethers, or combinations thereof where alkyl contains 1 to 4 carbon atoms.

Optionally, the photopolymerizable compositions may also contain a plasticizer to modify adhesion, flexibility, hardness, solubility, film-forming properties, and other mechanical or chemical properties required during its processing or end use. Suitable plasticizers include triethylene glycol, triethylene glycol diacetate, triethylene glycol dipropionate, triethylene glycol dicaprylate, triethylene glycol dimethyl ether, triethylene glycol bis(2-ethylhexanoate), tetraethylene glycol diheptanoate, poly(ethylene glycol), poly(ethylene glycol) methyl ether, isopropylnaphthalene, diisopropylnaphthalene, poly(propylene glycol), glyceryl tributyrate, diethyl adipate, diethyl sebacate, dibutyl suberate, dioctyl phthalate, tricresyl phosphate, tributyl phosphate, and tris(2-ethylhexyl) phosphate.

Other examples of suitable plasticizers include modified or unmodified natural oils and resins; paraffinic mineral oils; alkyl, alkenyl, arylalkyl or arylalkenyl esters of acids, such as alkanoic acids or arylcarboxylic acids; aliphatic hydrocarbon oils, e.g., naphthenic and paraffinic oils; liquid polydienes, e.g., liquid polybutadiene, and liquid polyisoprene; and liquid oligomeric acrylonitrile-butadiene copolymers. Generally, plasticizers are liquids having molecular weights of less than about 5000, but can have molecular weights up to about 30,000. Plasticizers having low molecular weight will encompass molecular weights less than about 30,000. In one embodiment, the plasticizer is present from 5 to 40 % by weight, based upon the composition.

The photopolymerizable composition can include other components such as thermal polymerization inhibitors or stabilizers, processing aids, antioxidants, antiozonants, antioxidants, adhesion promoters, fillers, adhesion modifiers, coating aids, antiozonants, dyes and pigments, optical brighteners and the like to modify the physical properties of layer, stabilize, color, or otherwise enhance the composition, in the photosensitive element for use as a microfluidic device. The photopolymerizable composition can include a chemically or thermally activated crosslinking agent may be incorporated to improve high temperature characteristics, chemical resistance or other mechanical or chemical properties required in the end-use of the microfluidic device. Dyes and pigments are not limited, however any colorant used should preferably be transparent to the actinic radiation used. Processing aids may be such things as low molecular weight polymers compatible with the elastomeric block copolymer, such as low molecular weight alpha-methylstyrene polymer or copolymer. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

The thickness of the layer of the photopolymerizable composition can vary over a wide range depending upon the needs of the microfluidic device desired, for example, from 0.025 cm to 0.64 cm or greater (0.010 inches to 0.250 inches or greater).

The support can be any flexible material that is conventionally used with photosensitive elements used to prepare the precursor. The support for photopolymerizable layer provides stability, strength, and protection to the microfluidic precursor during preparation steps and to the microfluidic device. The support can also serve as a barrier to air for a microfluidic device that prevents or minimizes the bulk degassed polymer of the device from prematurely re-adsorbing ambient air during end-use. In most embodiments, the support remains with the photosensitive element during preparation steps to form the microfluidic device, and is included with the microfluidic device in end use. The support can be single layer or multilayer, and can be in any form. In most embodiments, the support is transparent to actinic radiation to accommodate "backflash" exposure through the support. Examples of suitable support materials include polymeric films such those formed by addition polymers and linear condensation polymers. Some non-limiting examples of polymeric materials suitable as the support film include, polystyrenes, polyethylenes, polypropylenes, polycarbonates, fluoropolymers, polyamides, and polyesters, Under certain end-use conditions, metals such as aluminum, may also be used as a support, even though a metal support is not transparent to radiation. A preferred support is a polyester film; particularly preferred is polyethylene terephthalate. The support may be in sheet form or in cylindrical form, such as a sleeve. The sleeve may be formed from single layer or multiple layers of flexible material. The support typically has a thickness from 0.002 to 0.050 inch (0.0051 to 0.127 cm). A preferred thickness for the sheet form is 0.003 to 0.016 inch (0.0076 to 0.040 cm).

Optionally, the photosensitive element can include an adhesive layer between the support and the photosensitive layer, or a surface of the support that is adjacent the photosensitive layer has an adhesion-promoting surface. The adhesive layer on the surface of the support can be a subbing layer of an adhesive material or primer or an anchor layer as disclosed in U.S. Patent 2,760,863 to give strong adherence between the support and the photopolymerizable layer. The adhesive compositions that are disclosed by Burg in U.S. Patent 3,036,913 are also effective. Alternatively, the surface of the support on which the photopolymerizable layer resides can be treated to promote adhesion between the support and the photopolymerizable layer, with flame-treatment or electron-treatment, e.g., corona-treated. Further, the adhesion of the photopolymerizable layer to the support can be adjusted by exposing the element to actinic radiation through the support as disclosed by Feinberg et al. in U.S. Patent 5,292,617.

The photosensitive element may further include a temporary coversheet on top of an uppermost layer of the element, which uppermost layer may be the photopolymerizable layer, or any of the additional layers. One purpose of the coversheet is to protect the uppermost layer of the photosensitive element during storage and handling. Typically, the temporary coversheet is removed from the element prior to imagewise exposure, but can be removed in some instances after imagewise exposure. The temporary coversheet is removed by peeling from the top or uppermost surface of the element. For some embodiments of digital-to-plate image processing, the coversheet is removed prior to exposing the infrared-sensitive layer to infrared laser radiation. Examples of suitable materials for the coversheet include a thin film of polystyrene, polyethylene, polypropylene, polycarbonate, fluoropolymers, polyamides, or polyesters, which film can be subbed with release layers. The coversheet is preferably prepared from polyester, such as Mylar® polyethylene terephthalate film; most preferably the coversheet is 2-mil thick Mylar® film.

Although a photosensitive element is typically used in sheet form, there is no limitation to the shape of the photosensitive element and can include a continuous cylindrical form. A continuous cylindrical form is one in which the photopolymerizable layer is formed into a cylindrical shape, typically on a cylindrically-shaped support.

The photopolymerizable composition itself can be prepared in many ways by admixing the binder, monomer, initiator, and other ingredients. It is preferred that the photopolymerizable composition be formed into a hot melt and then calendered to a layer of the desired thickness. An extruder can be used to perform the functions of melting, mixing, deaerating and filtering the composition. The extruded mixture is then calendered between the support and the temporary coversheet. Alternatively, the photopolymerizable material can be placed between the support and the temporary coversheet in a mold device, which presses the layers of material flat by the application of heat and/or pressure. In this alternative embodiment, the photopolymerizable material is pressed flat without the presence of a relief-forming mold or master, that is, unlike conventional soft lithographic methods, no relief mold or master is included in the mold pressing device.

The photosensitive element includes at least one photopolymerizable layer, and thus can be a bi- or multi- layer construction. The photosensitive element may also include one or more additional layers on the side of the photosensitive layer opposite the support. In some embodiments, the one or more additional layers are independently formed on the temporary coversheet and introduced during calendering of the photopolymerizable layer to form the photosensitive element. Other methods to form the photosensitive element with one or more additional layers are well within the skill of those in the art. The one or more additional layers preferably are removable, in whole or in part, during treatment to form the relief image. Examples of additional layers include, but are not limited to, a release layer, a capping layer, an elastomeric layer, a laser radiation-sensitive layer, an actinic radiation opaque layer, a barrier layer, and combinations thereof. The laser radiation-sensitive layer and/or the actinic radiation opaque layer may also be referred to as a digital layer herein. One or more of the additional other layers can cover or only partially cover the photosensitive composition layer. An example of an additional layer which only partially covers the photosensitive composition layer is a masking layer that is formed by imagewise application, e.g., ink jet application, of an actinic radiation blocking material or ink.

In general, the surface of the photopolymerizable layer (opposite the support) may be tacky and a release layer having a substantially non-tacky surface can be applied to the surface of the photopolymerizable layer. Such release layer can protect the surface of the photopolymerizable layer from being damaged during removal of an optional temporary coversheet and can ensure that the photopolymerizable layer does not stick to the coversheet. During imagewise exposure, the release layer can prevent the image-bearing mask, i.e., phototool, from binding with the photopolymerizable layer. The release layer is insensitive to actinic radiation. The release layer is also suitable as a first embodiment of the barrier layer which is optionally interposed between the photopolymerizable layer and the actinic radiation opaque layer. The elastomeric capping layer may also function as a second embodiment of the barrier layer. Examples of suitable materials for the release layer are include, but are not limited to, polyamides, polyvinyl alcohol, hydroxyalkyl cellulose, copolymers of ethylene and vinyl acetate, amphoteric interpolymers, and combinations thereof. Other examples of materials suitable for the release layer include cellulose acetate butyrate, alkyl cellulose, butyral, cyclic rubbers, and combinations thereof. Materials suitable for the release layer can also function as a barrier layer to a digital layer, i.e., the actinic radiation opaque layer or laser-radiation sensitive layer.

The elastomeric capping layer can be considered an example of a photosensitive element having a bi-layer construction. The composition of the elastomeric capping layer includes an elastomeric polymeric binder, an optional second polymeric binder and optionally a nonmigratory dye or pigment. The elastomeric capping composition can also contain a monomer or monomers and a photoinitiating system. In some embodiments, the elastomeric polymeric binder in the elastomeric composition is the same as or similar to the elastomeric binder present in the photopolymerizable layer. In most embodiments, the elastomeric capping layer is disposed on, in direct contact with, the photopolymerizable layer. The elastomeric capping layer is typically part of a multilayer cover element that becomes part of the photosensitive element during preparation of the photopolymerizable layer. Such multilayer cover elements and compositions suitable as the elastomeric capping layer are disclosed in Gruetzmacher et al., U.S. 4,427,759 and U.S. 4,460,675. Although the composition that forms the elastomeric capping layer may not necessarily initially contain photoreactive components, the layer ultimately becomes photosensitive when in contact with the photopolymerizable layer. As such, upon imagewise exposure to actinic radiation, the elastomeric capping layer has portions in which polymerization or crosslinking occurred and portions which remain unpolymerized, i.e., uncrosslinked. The elastomeric capping layer is similar to the photosensitive layer in that after imagewise exposure the elastomeric capping layer is at least partially removable (i.e., the unexposed portions) during treatment to form the relief. The elastomeric capping layer should have an elastic modulus in the polymerized state not substantially less than the elastic modulus of the photopolymerizable layer in the exposed state. In some embodiments, the elastomeric capping layer can also function as a barrier layer to the actinic radiation opaque layer or laser-radiation sensitive layer.

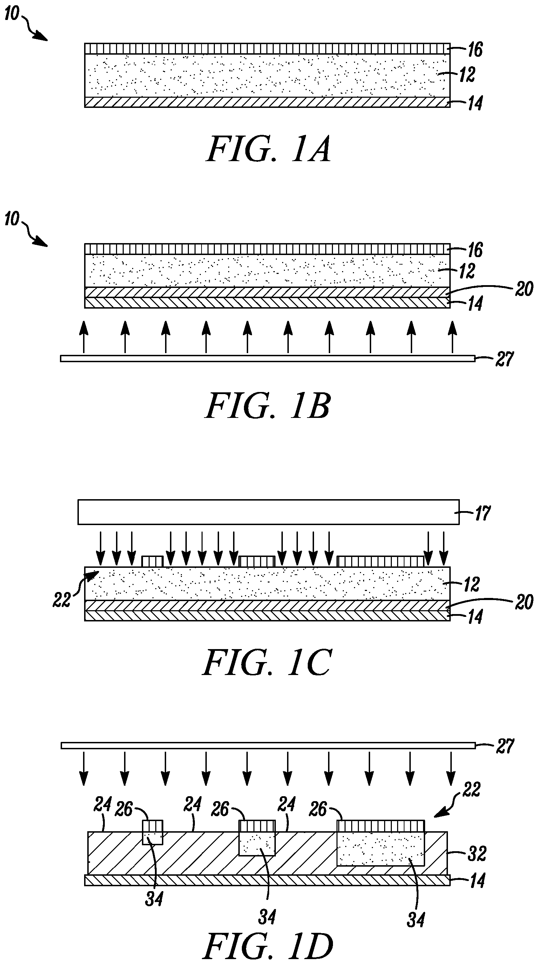

FIG. 1A is one embodiment of a photosensitive element 10 for use in the preparation of a microfluidic device according to the present invention. The element 10 includes a layer 12 of a photopolymerizable composition adjacent a support 14 and a digital layer 16 that is disposed above the photopolymerizable layer on a side opposite the support. The digital layer 16 is opaque or substantially opaque to non-infrared actinic radiation and sensitive to infrared radiation.

In some embodiments the photosensitive element includes one or more layers that alone or together provide digital direct-to-plate image technology to form the mask of the image for the photosensitive element (instead of the conventional image transparency or phototool). Layer or layers involved with digital mask formation can be referred to as a laser radiation sensitive layer, or an actinic radiation opaque layer, or a mask forming layer, or digital layer. In most embodiments, digital methods create a mask image *in situ* on or disposed above the photopolymerizable layer with laser radiation. Digital methods of creating the mask image require one or more steps to prepare the photosensitive element prior to imagewise exposure to actinic radiation. Generally, digital methods of mask formation involve use of laser radiation to create a mask image for use with the photosensitive element. In some embodiments, digital methods form an in-situ mask on the photosensitive element by either selectively removing or transferring portions of a digital layer/s that are sensitive to laser radiation and opaque to actinic radiation, from or to a surface of the photosensitive element opposite the support. The actinic radiation opaque layer is opaque or substantially opaque to actinic radiation that corresponds with the sensitivity of the photopolymerizable material. The method by which the mask is formed with the digital layer on the photosensitive element is not limited. In some embodiments, the photosensitive element includes one layer that is sensitive to laser radiation and an adjacent layer that is opaque to actinic radiation, which combined is considered a digital layer. In most embodiments a single layer, i.e., the digital layer, provides both sensitivity to laser radiation and is opaque to actinic radiation. The digital layer can be used alone or with other layers, e.g., ejection layer, heating layer, etc. The thickness of the digital layer should be in a range to optimize both sensitivity and opacity, which is generally from about 20 Angstroms to about 50 micrometers, and should have a transmission optical density of greater than 2.0 in order to effectively block actinic radiation and the polymerization of the underlying photopolymerizable layer. The digital layer can be on or adjacent the photosensitive layer, or on a barrier layer which is adjacent the photosensitive layer, or on a temporary support which together with the photosensitive element form an assemblage.

In one embodiment, the photopolymerizable element includes the digital layer that is disposed on or above a surface of the photopolymerizable layer opposite the support, and covers or substantially covers the entire surface of the photopolymerizable layer. The digital layer is sensitive to infrared laser radiation and can be removed from the photosensitive layer on the side opposite the flexible substrate by exposure to infrared laser radiation. In this case the infrared laser radiation imagewise removes, i.e., ablates or vaporizes, the digital layer to form the in-situ mask that is also opaque to actinic radiation. Suitable materials and structures for this digital layer are disclosed in U.S. Patents 5,262,275; U.S. 5,719,009; U.S. 6,558,876; U.S. 6,238,837; U.S. 6,929,898; U.S. 5,506,086 and 5,705,310; and, EP 0 741 330 A1;. A material capture sheet adjacent the digital layer may be present during laser exposure to capture the material as it is removed from the photosensitive element as disclosed in U.S. Patent 5,705,310. Only the portions of the digital layer that were not removed from the photosensitive element will remain on the element forming the in-situ mask.

In another embodiment, the photosensitive element may not initially include the digital layer. A separate element bearing the digital layer will form an assemblage with the photosensitive element such that the digital layer is adjacent the surface of the photosensitive element opposite the support, which is typically is the photopolymerizable layer. (If present, a coversheet associated with the photosensitive element typically is removed prior to forming the assemblage.) The separate element may include one or more other layers, such as ejection layers or heating layers, to aid in the digital exposure process. In this case, the photosensitive element forms an assemblage with a temporary support carrying the digital layer, and portions of the digital layer are transferred from the temporary support to the external surface (the side opposite the substrate) of the photosensitive layer by exposure to infrared laser radiation. The digital layer of the assemblage is exposed imagewise with infrared laser radiation to selectively transfer or selectively alter the adhesion balance of the radiation opaque layer and form the image on or disposed above the photopolymerizable layer. The separate element may be peeled or lifted away from the photosensitive element to reveal the in-situ mask. Materials and structures suitable for this actinic digital layer are disclosed in U.S. Patent 5,607,814; U.S. Patents 5,766,819; 5,840,463; and EP 0 891 877A. As a result of the imagewise transfer process, only the transferred portions of the digital layer will reside on the photosensitive element forming the in-situ mask.

In another embodiment, digital mask formation can be accomplished by laser imaging a digital layer of a digital element that is separate from the photopolymerizable layer, and subsequently the digital element with the mask is applied on or adjacent to the photopolymerizable layer of the photosensitive element. In this embodiment, instead of being generated from a silver halide film, the digital mask is formed on an digitally imageable element that is independent of the photosensitive element, which can be formed by any of the following methods including, but not limited to, ablation of an ablatable layer, melt-stick transfer, laser-induced film transfer, peel apart, dye-sublimation, and dye diffusion. The digital mask image can be brought into contact or transferred with application of heat and/or pressure to the surface of the photopolymerizable layer opposite the support.

In yet another embodiment, mask formation can be digitally accomplished by imagewise application of a radiation opaque material in the form of inkjet inks. Imagewise application of an ink-jet ink can be directly on the photopolymerizable layer or disposed above the photopolymerizable layer on another layer of the photosensitive element. The mask formed by ink jet application of radiation opaque material or ink onto the photosensitive element is also considered a digital layer. The photosensitive element may include an ink receptive layer on or disposed above the photopolymerizable layer, examples of which are disclosed in published patent applications WO 2013/027220 A2; EP 1637322 A; EP 1349004 A; and US 2006/0073417. Examples of ink jet inks and suitable methods for forming a mask for the photosensitive element are disclosed in US 2012/0045583; US 2006/0075917; US 2004/0244643; and, EP 1637322 A.

In some embodiments, the digital layer/s generally includes an infrared-absorbing material, a radiation-opaque material, and an optional binder. Dark inorganic pigments, such as carbon black and graphite, mixtures of pigments, metals, and metal alloys generally function as both infrared-sensitive material and radiation-opaque material. The optional binder is a polymeric material which includes, but is not limited to, self-oxidizing polymers; non-self-oxidizing polymers; thermochemically decomposable polymers; polymers and copolymers of butadiene and isoprene with styrene and/or olefins; pyrolyzable polymers; amphoteric interpolymers; polyethylene wax, materials conventionally used as a release layer, such as polyamides, polyvinyl alcohol, hydroxyalkyl cellulose, and copolymers of ethylene and vinyl acetate; and combinations thereof. Such digital layer can be considered a photoablative or phototransferable layer that can be employed digital direct-to-plate image technology in which the exposure by laser radiation removes or transfers the digital layer to form an in-situ mask of a radiation opaque material on the photosensitive element. Suitable infrared-sensitive compositions, elements, and their preparation are disclosed in U.S. Patents 5,262,275; U.S. 5,719,009; U.S. 5,607,814; U.S. 5,506,086; U.S. 5,766,819; U.S. 5,840,463; U.S. 6,238,837; and U.S. 6,929,898.

The photosensitive element that includes a solid photopolymerizable layer and the optional support can have a durometer of about 15 to about 65 Shore A. In some embodiments, the photosensitive element has a durometer of about 17 to about 60 Shore A. The microfluidic precursor (i.e., after exposure (and treating) of the photosensitive element) that includes a solid polymeric layer adjacent the support can have a durometer of about 20 to about 85 Shore A. In some embodiments, the microfluidic precursor has a durometer of about 25 to about 80 Shore A. The Shore durometer is a measure of the resistance of a material toward indentation. Durometer of Shore A is the scale typically used for soft rubbers or elastomeric materials, where the higher the value the greater the resistance toward penetration. In general for the same photopolymerizable composition of a photosensitive element, the greater thickness of the photopolymerizable layer will have a lower Shore A durometer. The durometer of the photosensitive element and the precursor can be measured according to standardized procedures described in DIN 53,505 or ASTM D2240-00.

In one embodiment the photosensitive element for use as a microfluidic device includes, adjacent an optional support, a layer of a photopolymerizable composition that includes a binder; one or more monomers; and a photoinitiator. This embodiment of the photosensitive element, and unless otherwise mentioned all subsequently identified embodiments of the photosensitive element, can be considered a photoimageable microfluidic device precursor element that includes a solid layer of the photopolymerizable composition that is selectively imageable and removable to form at least one channel for transporting a fluid therein.

In one embodiment, the photosensitive element includes, adjacent an optional support, a layer of a photopolymerizable composition that includes a binder; one or more monomers; and a photoinitiator, and a digital layer disposed on or above or adjacent to a side of the photopolymerizable layer that is opposite the optional support.

In one embodiment the photosensitive element includes adjacent a support a layer of a photopolymerizable composition that includes a binder, preferably an elastomeric binder; one or more monomers; and a photoinitiator, and optionally a digital layer disposed above a side of the photopolymerizable layer that is opposite the support, wherein the elastomeric binder is selected from any one polymer or, independently selected groups of two or more polymers, that includes natural polymers or synthetic polymers of conjugated diolefin hydrocarbons; block copolymers comprising a non-elastomeric block of vinyl polymer and an elastomeric block of a conjugated diene; nitrile elastomers; polybutylene elastomers; polyalkyleneoxides; elastomeric polymers and copolymers of acrylates and methacrylates; elastomeric polyurethanes; elastomeric polyesters; elastomeric polymers and copolymers of ethylene-propylene; elastomeric polymers of ethylene-propylene-diene; elastomeric copolymers of vinyl acetate and its partially hydrogenated derivatives; block copolymers comprising a non-elastomeric block of vinyl polymer and an elastomeric block of a conjugated diene that are chemically modified with fluoroalkyl groups or with fluoroalkyl side chains or with hydroxyl side groups; and combinations thereof.

In one embodiment the photosensitive element includes adjacent a support a layer of a photopolymerizable composition that includes an elastomeric binder; one or more monomers; and a photoinitiator, and optionally a digital layer disposed above a side of the photopolymerizable layer that is opposite the support, wherein the elastomeric binder forms a matrix for the one or more monomers and the photoinitiator so that the photopolymerizable layer is a solid elastomeric layer, and wherein the elastomeric binder is selected from natural polymers or synthetic polymers of conjugated diolefin hydrocarbons; block copolymers comprising a non-elastomeric block of vinyl polymer and an elastomeric block of a conjugated diene; nitrile elastomers; polybutylene elastomers; polyalkyleneoxides; elastomeric polymers and copolymers of ethylene-propylene; elastomeric polymers of ethylene-propylene-diene; elastomeric copolymers of vinyl acetate and its partially hydrogenated derivatives; block copolymers comprising a non-elastomeric block of vinyl polymer and an elastomeric block of a conjugated diene that are chemically modified with fluoroalkyl groups, with fluoroalkyl side chains, or with hydroxyl side groups; and combinations thereof.

In one embodiment the photosensitive element includes adjacent a support a layer of a photopolymerizable composition that includes a binder that is an elastomeric block copolymer comprising a non-elastomeric block of vinyl polymer and an elastomeric block of a conjugated diene represented as A-B-A block copolymer, where A represents the non-elastomeric block and B represents the elastomeric block; one or more monomers selected from acrylate monoesters of alcohols and polyols; acrylate polyesters of alcohols and polyols; methacrylate monoesters of alcohols and polyols; and methacrylate polyesters of alcohols and polyols; and a photoinitiator; and optionally a digital layer disposed above a side of the photopolymerizable layer that is opposite the support.

In another embodiment the photosensitive element includes adjacent a support a layer of a photopolymerizable composition that includes an elastomeric binder that is an elastomeric block copolymer selected from poly(styrene/butadiene/styrene) copolymers, poly(styrene/isoprene/styrene) copolymers, poly(styrene/isoprene-butadiene/styrene) copolymers, poly(styrene/butadiene/styrene) copolymers that are modified to have fluoroalkyl groups or fluoroalkyl side chains or side chains with hydroxyl groups, poly(styrene/isoprene/styrene) copolymers that are modified to have fluoroalkyl groups or fluoroalkyl side chains or side chains with hydroxyl groups, poly(styrene/isoprene-butadiene/styrene) copolymers that are modified to have fluoroalkyl groups or fluoroalkyl side chains or side chains with hydroxyl groups, poly(styrene-ethylene- butylene-styrene) copolymers, poly(styrene-ethylene propylene- styrene) copolymers, and combinations thereof; one or more monomers; and a photoinitiator; and optionally a digital layer disposed above a side of the photopolymerizable layer that is opposite the support.

In one embodiment, the photosensitive element includes adjacent a support a layer of a photopolymerizable composition that includes a binder; one or more monomers; and a photoinitiator; and disposed above the photopolymerizable layer opposite the support, a digital layer which is remoavable, i.e., ablatable by infrared radiation and opaque to non-infrared actinic radiation, wherein the infrared ablation layer comprises (i) at least one infrared absorbing material; (ii) a radiation opaque material, wherein (i) and (ii) can be the same or different; and optionally, (iii) at least one binder selected from self-oxidizing polymers; non-self-oxidizing polymers; thermochemically decomposable polymers; polymers and copolymers of butadiene and isoprene with styrene and/or olefins; pyrolyzable polymers; amphoteric interpolymers; polyethylene wax, polyamides, polyvinyl alcohols, hydroxyalkyl celluloses, and copolymers of ethylene and vinyl acetate; cellulose acetate butyrate, alkyl cellulose, butyral, cyclic rubbers, and combinations thereof.

### Method for Making a Microfluidic Precursor and Device

The method for making a microfluidic precursor from a photosensitive element as described above includes the steps of imagewise exposing the photosensitive element to actinic radiation to selectively polymerize portions of the photopolymerizable layer; and, treating the resulting element to remove unpolymerized portions of the photopolymerizable layer to form the microfluidic precursor having a relief surface suitable for transport of a fluid.

Referring to FIG. 1B through FIG. 1H, steps of one embodiment of a method for making a microfluidic precursor and a microfluidic device from the photosensitive element 10 of FIG 1A are shown. In FIG. 1B the photosensitive element 10 is overall exposed to actinic radiation, which in this embodiment is ultraviolet radiation, through the support 14 to form a floor 20 of the photopolymerizable layer 12. In FIG. 1C the digital layer 16 of the element 10 is imagewise exposed to infrared laser radiation from a source 17 to remove, i.e., vaporize, ablate, and/or disperse, areas of the digital layer 16, and thereby form an in-situ mask 22 disposed above the photopolymerizable layer 12. The mask 22 includes a pattern of clear or substantially clear areas 24 in which the digital layer 16 has been removed by the laser radiation, and opaque or substantially opaque areas 26 in which the digital layer remained with the element 10. The pattern will create a relief surface of the photopolymer layer of recessed microstructures that are useful in microfluidic devices.

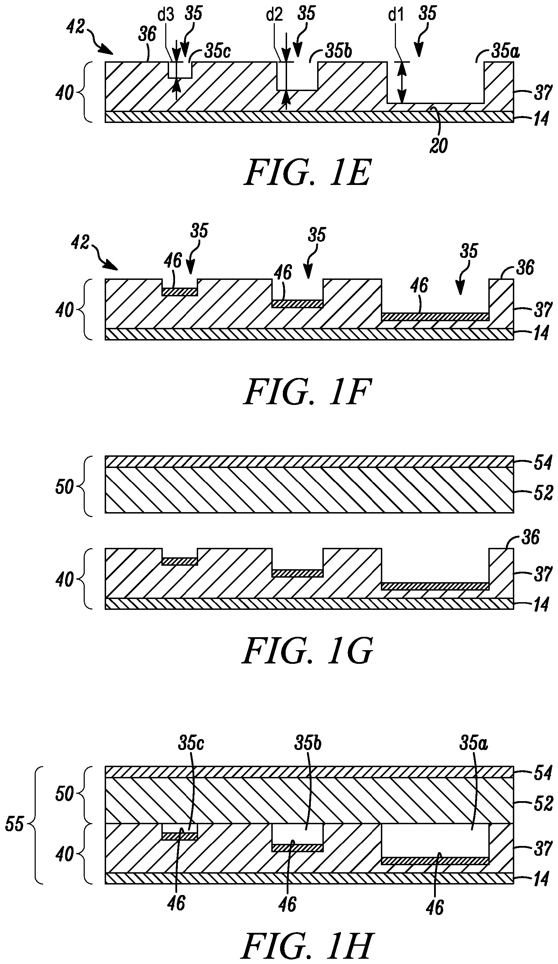

In FIG. 1D the photopolymerizable layer 12 of the element 10 is imagewise exposed to ultraviolet radiation from a source 27. The ultraviolet radiation passes through clear areas 24 of the mask 22 to expose and thereby polymerize or substantially polymerize, i.e., cure or substantially cure, the underlying photopolymerizable layer 12 and form the cured portions or areas 32 of the layer. The opaque areas 26 of the mask 22 prevent or substantially prevent the ultraviolet radiation from exposing the underlying photopolymerizable layer 12, and form the uncured or unpolymerized portions or areas 34 of the layer. Since the photopolymerizable layer 12 is now cured to the floor 20 that is also cured, the floor 20 is essentially no longer separately distinguishable from the cured portion 32 of the layer 12; and as such, the floor 20 is not specified in subsequent FIGS. 1E - 1H. FIG. 1D show a different depth of each of the uncured portions 34 of the photopolymerizable layer 12 which is due in part to the angular distribution (not shown) of the incident rays of the ultraviolet radiation that go through the clear areas 24 of the mask 22 during imagewise exposure to cause crosslinking of the photopolymerizable layer 12 in areas that underlie the opaque areas 26 of the mask 22.

In FIG. 1E after treating by heat or washout in solution (not shown), the uncured portions 34 of the photopolymerizable layer 12 are removed and the element 10 is a microfluidic precursor 40 having a relief surface 42 in which a layer 37 of cured portions 32 of the now polymerized material will form the microstructures for the device. The cured polymeric layer 37 having the relief surface 42 will serve as a channel-bearing layer having at least one of the recessed areas, e.g., at least one channel, for transporting a fluid therein. The removed uncured portions 34 form the recessed portions or areas 35 of the relief surface 42, which in this embodiment will become chambers for the diagnostic reagent 46 of the microfluidic device 55. The recessed portion 35a is a chamber that has a depth d1 that extends from an uppermost or top surface 36 of the cured polymeric layer 37 to the floor 20. The uppermost surface or top surface 36 of the cured polymeric layer 37 may also be referred to as an exterior surface 36 of the relief surface 42. The recessed portion 35b is a chamber that has a depth d2 that extends from the top surface 36 of the cured polymeric layer 37 to a location in the cured layer 37 above the floor 20 (not shown in FIG. 1E). The recessed portion 35c is a chamber that has a depth d3 that extends from the top surface 35 of the cured polymeric layer 37 to a different location (than that for depth d2) in the cured layer 37 above the floor 20 (not shown). The recessed portions 35b and 35c each have a different depth d2 and d3 respectively that is shallower than the depth d1 of the recessed portion 35a. The depth of a recessed portion 35 is measured from the top surface 36 to the deepest or substantially deepest (i.e., lowest or substantially lowest) location in the recessed portion which in most embodiments is in a central or middle location of the recessed portion. Several measurements can be taken and an average value used.

The precursor 40 of FIG. 1F includes the relief surface 42 having recessed areas 35 that are open for the optional application of a diagnostic reagent which is typically dried to form a layer 46. In the embodiment shown, the recessed areas 35 with the diagnostic reagent 46 form chambers of the microfluidic device; and the chambers are connected by branches (not shown) to a main channel (not shown).

In FIG. 1G, a cover member 50 that includes a layer 52 of polymerized material adjacent to a support 54 is being positioned for application or placement to the exterior surface 36 of a side of the precursor 40 having the relief surface 42 of microstructures. In this embodiment, the cover member 50 has been separately prepared from a photosensitive element similar to the photosensitive element 10 of FIG. 1A by overall exposing the photopolymerizable layer to ultraviolet radiation through a support 54 and through the side opposite the support 54 without a mask present. In FIG. 1H the cover member 50 is attached to the exterior surface 36 of the precursor 40, covering or enclosing the open recessed areas 35 and trapping or encapsulating the diagnostic reagent 46 in the chambers, and forming a microfluidic device 55. Thereafter, the microfluidic device 55 is placed in a sealable bag (not shown) and a vacuum drawn to remove air from the channel/s and degas the polymeric material 37 of the device 55 and the bag.

Imagewise exposure can be carried out by exposing the photosensitive element through an image-bearing mask that can be a separate film, i.e., an image-bearing photomask or phototool, which can be referred to as an analog exposure or analog workflow; or, be integrated with the photosensitive element as an in-situ mask formed by computer-to-plate digital imaging, which can be referred to as digital exposure, or digital workflow. The mask includes an image having opaque areas and transparent or "clear" areas. The mask image of the photosensitive element ultimately creates the pattern of relief areas for the precursor.

In some embodiments imagewise exposure can be carried out by exposing the photosensitive element through the image-bearing mask or phototool. The image-bearing mask, a black and white transparency or negative can be made from a silver halides film or by other means known in the art. The image-bearing mask is placed on top of the photosensitive element after first stripping off the temporary coversheet. In one embodiment, imagewise exposure can be carried out in a vacuum frame, which provides proper contact of the image-bearing mask and the uppermost surface of the photosensitive element, and removes atmospheric oxygen which is known to interfere with the free-radical polymerization process.

In another embodiment, the image-bearing mask is place on top of the photosensitive element and laminated under heat and/or pressure to the photosensitive element as disclosed by Zwadlo in U.S. Patent 7,279,254; and in U.S. Patents 7,807,001, and 7,802,598. In this embodiment, instead of being generated from a silver halide film, the image-bearing mask can be formed on an imageable element, typically by a digital method involving laser imaging, that is independent of the photosensitive element by any of the following methods including, but not limited to, ablation of an ablatable layer, melt-stick transfer, laser-induced film transfer, peel apart, dye-sublimation, and dye diffusion. The digital mask is applied to the exterior surface of the photosensitive element and transferred by lamination with or without the application of heat and/or pressure to the surface of the photopolymerizable layer opposite the support. The photopolymerizable layer is typically tacky and will retain the transferred image. A carrier that included the digital layer of the imageable element can then be removed from the element prior to imagewise exposure, or if transparent to actinic radiation may remain. The photosensitive element is then exposed blanket exposed to actinic radiation through the mask. The phototool or image-bearing mask is removed after exposure through the mask.

In some other embodiments, imagewise exposure can be carried out by exposing the photosensitive element through a mask that is integrated with the photosensitive element, so called in-situ mask, formed by computer-to-plate digital imaging of the digital layer. The in-situ mask image is formed on or disposed above the surface of the photopolymerizable layer opposite the support. The in-situ mask can be generated by any suitable method, including digital direct-to-plate methods using laser radiation and inkjet application that are conducted prior to imagewise exposure of the photosensitive element to actinic radiation.

In digital direct-to-plate image technology, laser radiation is used to form the in-situ mask of the image for the photosensitive element. Generally, digital methods of in-situ mask formation use the laser radiation to either selectively remove or transfer a digital layer from or to a surface of the photosensitive element opposite the support. For direct-to-plate image formation as disclosed in U.S. Patents 5,262,275; US 5,719,009; US Patent 5,607,814; US 5,506,086; US 5,766,819; US 5,840,463; US 6,238,837; US 6,558,876; and US 6,773,859 the image-bearing mask is formed in-situ with the digital layer using an infrared laser exposure engine. Imagewise exposure of precursor through such a photoablative mask can be done without using a vacuum frame, simplifying the precursor making process. In most embodiments exposure process involves (1) imagewise removing the digital layer of the photosensitive element described above to form a mask on or adjacent the photopolymerizable layer; and (2) overall exposing the photosensitive element to actinic radiation through the mask.

In most embodiments, the laser radiation for imagewise laser exposure is carried out using various types of infrared lasers, which emit in the range 750 to 20,000 nm, preferably in the range 780 to 2,000 nm. Diode lasers may be used, but Nd:YAG lasers emitting at 1060 nm are preferred. A preferred apparatus and method for infrared laser exposure to imagewise remove the actinic radiation opaque layer from the photosensitive element is disclosed by Fan et al. in U.S. Patents 5,760,880 and 5,654,125. The in situ mask image remains on the photosensitive element for the subsequent step of overall exposure to actinic radiation, and in most embodiments for the treating step where the in-situ mask is removed.

Regardless of the embodiment by which the mask is created for the photosensitive element, the mask will include opaque areas and "clear" or transparent areas, which represent the pattern of the microstructure desired for the microfluidic device. The opaque areas of the mask prevent the photopolymerizable material beneath from being exposed to the radiation and hence those areas of the photopolymerizable layer covered by the dark areas do not polymerize, i.e., uncured portions of the layer. The "clear" areas of the mask expose the photopolymerizable layer to actinic radiation and polymerize or crosslink, i.e., cured portions of the layer.

Upon exposure of the photosensitive element through the mask to actinic radiation, the transparent areas of the negative allow the actinic radiation to pass through the mask to impinge on the underlying photopolymerizable layer and cause addition polymerization or crosslinking to occur in the exposed areas of the layer, while the opaque areas prevent actinic radiation from impinging the underlying areas of the photopolymerizable layer and thus remain uncrosslinked. Exposure is of sufficient duration to crosslink the exposed areas down to the support or to the back exposed layer. Imagewise exposure time is typically much longer than backflash time, and ranges from a few to tens of minutes. Upon imagewise exposure, the radiation-exposed areas of the photopolymerizable layer are converted to the insoluble state with no significant polymerization or crosslinking taking place in the unexposed areas of the layer.

Any conventional source of actinic radiation can be used for this exposure. Actinic radiation sources encompass the ultraviolet and visible wavelength regions, although in most embodiments the radiation sources generally emit UV radiation between 310-400 nm. The suitability of a particular actinic radiation source is governed by the photosensitivity of the initiator and the at least one monomer used in preparing the photosensitive element. The preferred photosensitivity of the photosensitive element is in the UV and deep visible area of the spectrum, as they afford better room-light stability. Examples of suitable visible and UV sources include carbon arcs, mercury-vapor arcs, fluorescent lamps, electron flash units, electron beam units, lasers, and photographic flood lamps. The most suitable sources of UV radiation are fluorescent lamps. Examples of industry standard radiation sources include the Sylvania 350 Blacklight fluorescent lamp (FR48T12/350 VL/VHO/180, 115w), and the Philips UV-A "TL"-series low-pressure mercury-vapor fluorescent lamps. These radiation sources generally emit long-wave UV radiation between 310-400 nm. Photosensitive elements sensitive to these particular UV sources use initiators that absorb between 310-400 nm. The exposure time may vary from a few seconds to tens of minutes, depending upon the intensity and spectral energy distribution of the radiation, its distance from the photosensitive element, the nature and amount of the photopolymerizable material, the desired image resolution, and the distance from the photosensitive element.

Imagewise exposure of the photosensitive element can occur under vacuum, or in the presence of atmospheric oxygen, or in an environment of an inert gas and a controlled concentration of oxygen that is less than atmospheric. In the embodiment in which the mask is a phototool, imagewise exposure of the photosensitive element occurs under vacuum in order for there to be intimate contact of the phototool to the photosensitive element. In the embodiments in which the mask is formed in-situ on the photosensitive element, imagewise exposure can occur in the presence of atmospheric oxygen or in a controlled environment of an inert gas and oxygen concentration. In other embodiments in which the mask is digitally formed and then forms an assemblage with the photosensitive element, imagewise exposure need not occur under vacuum since the digital mask is in intimate contact with the photosensitive element typically by lamination, and atmospheric oxygen is effectively minimized or blocked. In another embodiment, a transparent coversheet having a desired degree of oxygen permeability is laminated with or without heat and/or pressure to the photosensitive element having an in-situ digital mask prior to imagewise exposure of the photosensitive element. Exposure temperatures are preferably ambient or slightly higher, i.e., about 20°C to about 35°C.

The exposure process usually includes a back exposure and a front image-wise exposure, although the former is not strictly necessary. The back exposure or "backflash" can take place before, after or during image-wise exposure. Backflash prior to image-wise exposure is generally preferred. Back flash time can range from a few seconds to about 10 minutes, and creates a shallow layer of polymerized material, or a floor, on the support side of the photopolymerizable layer and sensitizes the photopolymerizable layers and the support, helps resolution and also establishes the depth of the relief. The floor improves adhesion of the photopolymerizable layer to the support, and provides better mechanical integrity to the photosensitive element.

The image-bearing mask includes at least one pattern that will form (upon treatment) features or microstructures in the photopolymerizable layer of the photosensitive element that are suitable for use in a microfluidic device. In most embodiments for end-use as a microfluidic device, the image-bearing mask includes at least one pattern that will form microstructures of at least one channel and at least one chamber, typically a plurality of chambers, in communication with the at least one channel used in a microfluidic device. In most embodiments, the image-bearing mask includes a plurality individual patterns that will form the microstructures for use in a plurality of microfluidic devices. In some other embodiments, the image-bearing mask that will form the microstructures also includes a pattern or patterns that will create one or more fill-enhancing duct/s directly or indirectly to one or more chambers in the device.

Following overall exposure to actinic radiation through the image-bearing mask, the photosensitive element is treated to remove unpolymerized areas of the photopolymerizable layer and thereby form a relief surface. Treatment of the photosensitive element can include (1) "wet" development wherein the photopolymerizable layer is contacted with a suitable developer solution to washout unpolymerized areas and (2) "dry" development wherein the photopolymerizable layer is heated to a development temperature which causes the unpolymerized areas to melt or soften and is contacted with an absorbent material to wick away or remove the unpolymerized material. Dry development may also be called thermal development.

Wet development is usually carried out at about room temperature. The developer solution can include an organic solvent, a mixture of organic solvents, an aqueous or a semi-aqueous solution, or water. The choice of the developer solution will depend primarily on the chemical nature of the photopolymerizable composition to be removed. A suitable organic solvent developer includes an aromatic or an aliphatic hydrocarbon, an aliphatic or an aromatic halohydrocarbon solvent, or a mixture of such solvents with a suitable alcohol. Other organic solvent developers have been disclosed in published German Application 38 28 551. A suitable semi-aqueous developer can contain water and a water miscible organic solvent and an alkaline material. A suitable aqueous developer can contain water and an alkaline material. Other suitable aqueous developer solution combinations are described in U.S. Patent No. 3,796,602.

Development time can vary, but it is preferably in the range of about 2 to about 25 minutes. The developer solution can be applied in any convenient manner, including immersion, spraying, and brush or roller application. Brushing aids can be used to remove the unpolymerized portions of the photosensitive element. Washout can be carried out in an automatic processing unit which uses developer and mechanical brushing action to remove the unexposed portions of the resulting precursor, leaving a relief structure of the exposed image pattern and the floor.

Following treatment by developing in solution, the precursors are generally blotted or wiped dry, and then more fully dried in a forced air or infrared oven. Drying times and temperatures may vary, however, typically the precursor can be dried for about 60 minutes to about 120 minutes at about 60°C.

Treating the photosensitive element thermally includes heating the photopolymerizable layer to a development temperature above about 40°C which causes the unpolymerized areas to liquefy, that is, to melt, soften, or flow. The photopolymerizable layer is capable of partially liquefying upon thermal development, that is, the uncured or unpolymerized material softens or melts or flows at a reasonable processing or developing temperature. The polymerized areas of the photopolymerizable layer have a higher melting temperature than the unpolymerized areas and therefore do not melt at the development temperatures (see U.S. 5,215,859 and WO 98/13730). If the photosensitive element includes one or more additional layers on the photopolymerizable layer, it is desirable (but not necessary) that the one or more additional layers are also removable in the range of acceptable developing temperatures for the photopolymerizable layer. The polymerized areas (cured portions) of the photopolymerizable layer have a higher melting temperature than the unpolymerized areas (uncured portions) and therefore do not melt, soften, or flow at the thermal development temperatures.

The uncured portions can be removed from the cured portions of the composition layer by any means including air or liquid stream under pressure as described in U.S. publication 2004/0048199 A1, vacuum as described in Japanese publication 53-008655, and contacting with an absorbent material as described in U.S. 3,060,023; U.S. 3,264,103; U.S. 5,015,556; U.S. 5,175,072; U.S. 5,215,859; U.S. Patent 5,279,697; and U.S. 6,797,454. In most embodiments, the unpolymerized portions or uncured portions are removed by contacting an outermost surface of the element to an absorbent surface, such as a development medium, to absorb or wick away or blot the melt or soften portions. It is contemplated that a combination of wet and dry treatments can be used to prepare the photosensitive element into a printing form. For example, one or more layers, such as the mask, on the exposed photosensitive element could be removed by wet development, and then the photosensitive element undergoes thermal treatment to remove the unpolymerized portions of the photopolymerizable layer.

The term "melt" is used to describe the behavior of the un-irradiated (uncured) portions of the composition layer subjected to an elevated temperature that softens and reduces the viscosity to permit absorption by the absorbent material. However throughout this specification the terms "melting", "softening", and "liquefying" may be used to describe the behavior of the heated un-irradiated portions of the composition layer, regardless of whether the composition may or may not have a sharp transition temperature between a solid and a liquid state. A wide temperature range may be utilized to "melt" the composition layer for the purposes of this invention. Absorption may be slower at lower temperatures and faster at higher temperatures during successful operation of the process.

The thermal treating steps of heating the photosensitive element and contacting an outermost surface of the element with development medium can be done at the same time, or in sequence provided that the uncured portions of the photopolymerizable layer are still soft or in a melt state when contacted with the development medium. The at least one photopolymerizable layer (and the additional layer/s) are heated by conduction, convection, radiation, or other heating methods to a temperature sufficient to effect melting of the uncured portions but not so high as to effect distortion of the cured portions of the layer. The one or more additional layers disposed above the photopolymerizable layer may soften or melt or flow and be absorbed as well by the development medium. The photosensitive element is heated to a surface temperature above about 40°C, preferably from about 40°C to about 230°C (104-446°F) in order to effect melting or flowing of the uncured portions of the photopolymerizable layer. By maintaining more or less intimate contact of the development medium with the photopolymerizable layer that is molten in the uncured regions, a transfer of the uncured photosensitive material from the photopolymerizable layer to the development medium takes place. While still in the heated condition, the development medium is separated from the cured photopolymerizable layer in contact with the support layer to reveal the relief structure. A cycle of the steps of heating the photopolymerizable layer and contacting the molten (portions) layer with the development medium can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the development medium to the photopolymerizable layer (while in the uncured portions are melt) may be maintained by the pressing the layer and the development medium together. Apparatuses suitable for thermal development of photosensitive elements are disclosed in U.S. 5,279,697 and U.S. 6,797,454.

The development medium is selected to have a melt temperature exceeding the melt or softening or liquefying temperature of the unirradiated or uncured portions of the radiation curable composition and having good tear resistance at the same operating temperatures. The selected material withstands temperatures required to process the photosensitive element during heating. The development medium may also be referred to herein as development material, absorbent material, absorbent web, and web. The development medium should also possess absorbency for the molten elastomeric composition. The development medium is selected from non-woven materials, paper stocks, fibrous woven material, open-celled foam materials, porous materials that contain more or less a substantial fraction of their included volume as void volume. The development medium can be in web or sheet form. In some embodiments, the development medium is a non-woven web of nylon or a non-woven web of polyester.

The precursor made using the photosensitive element of the present invention can optionally be uniformly post-exposed to ensure that the photopolymerization process is complete and that the photosensitive element will remain stable in use and storage. This post-exposure step can utilize the same radiation source as the main exposure.

Detackification is an optional post-development treatment which can be applied if the surface of the precursor is still tacky, such tackiness not generally being removed in post-exposure. Tackiness can be eliminated by methods well known in the art, such as treatment with bromine or chlorine solutions, and by exposure to radiation sources having a wavelength not longer than 300 nm. In some embodiments of the photosensitive element, the relief surface of the treated element i.e., precursor, is tacky or sticky or oily to the touch, or slightly tacky, sticky, or oily to the touch. In some embodiments, the treated precursor with relief does not undergo any of the above suggested methods to remove the tackiness on the relief surface. The inherent tackiness of the relief surface, particularly the exterior surface opposite the support, can be desirable, as the tackiness of the relief surface can be used to an advantage to aid the cover member mating to the relief surface of the microfluidic precursor.

Optionally, the mating surface of the precursor and/or a mating surface of the cover member can be given a corona treatment to enhance mating of the precursor and cover member.

In an alternate embodiment, the method for making a microfluidic precursor includes the steps of providing the photosensitive element of the present invention as described above; suitably reinforcing the photosensitive element with heat, radiation, or other means; and then imagewise exposing the photosensitive element to laser radiation to engrave or selectively remove portions of the reinforced photopolymerizable layer in depth. This alternative embodiment avoids the formation and use of a mask, and treating to form the relief surface desired for microfluidic precursor, but still provides the capability of creating microstructures of different dimensions.

In another alternate embodiment the photosensitive element may be suitably reinforced and then imagewise exposed to laser radiation to engrave or remove the reinforced layer in depth imagewise. U.S. Patents No. 5,798,202; U.S. 5,804,353; and U.S. 6,757,216 B2 disclose suitable processes for making a relief pattern in a photosensitive element by laser engraving a reinforced elastomeric layer on a flexible support. The processes disclosed in U.S. Patents No. 5,798,202 and 5,804,353 involve reinforcing and laser engraving a single-layer, or one or more layers of a multi-layer, of a photosensitive element comprised of a reinforced elastomeric layer on a flexible support. The elastomeric layer is reinforced mechanically, or thermochemically, or photochemically or combinations thereof. Mechanical reinforcement is provided by incorporating reinforcing agents, such as finely divided particulate material, into the elastomeric layer. Photochemical reinforcement is accomplished by incorporating photohardenable materials into the elastomeric layer and exposing the layer to actinic radiation. In general, reinforceable photosensitive elements suitable for forming the relief pattern by laser engraving are the same or can be substantially the same as for the photosensitive element described above.

The present method utilizes direct imaging through a mask to create the relief structure of features suitable for use in a microfluidic device and, in most embodiments; the features comprise at least one channel and at least one chamber. Direct imaging with a mask provides an advantage of controlled feature sizes and profiles over prior art soft lithography method. The present invention provides the capability to produce channels and chambers of different dimensions, particularly different depths, for the microfluidic device. The prior art soft lithography method produces microfluidic devices having the same depth of the channels and chambers since the device is prepared from a master that is a mold having features created by a layer of photoresist material. The present invention of direct imaging provides the capability to produce recessed areas in the photopolymerizable layer that can have different channel profiles and sizes, and thereby can provide a single microfluidic device to be a diagnostic tool for multiple reagents or pathogens that require different reactive amounts and/or different concentrations. Also, control of the channel size allows for control of flow rate and linear velocity of fluids within the device.

The ability to create channel and chamber microstructures of different dimensions, particularly depths, by direct imaging is due in part to the angular distribution of the incident rays of actinic radiation that impinge through the clear or open areas of the mask that cause crosslinking or curing of the photopolymerizable layer in areas that were not directly exposed to actinic radiation at the surface of the layer, i.e., areas of the photopolymerizable layer underlying the opaque areas of the mask. That is, for reverse images some portion of the non-imaged area of the photopolymerizable layer will cure and fill-in, resulting in less depth of the recessed area. The width of channel and chamber microstructures can be controlled primarily by the width of the opaque areas of the mask; and, the depth of channel and chamber microstructures can be influenced by the width of the opaque area relative to the width (or area) of the clear or open areas that surround the opaque area of the mask. Other factors that can influence the creation of microstructures of different dimensions, particularly depths, include but is not limited to the formulation of the photopolymerizable composition particularly as it determines the exposure latitude of the photopolymerizable composition at a given set of imagewise exposure conditions; the width of the opaque and clear features in the mask, and their proximity to one another; use of analog or digital exposure; concentration of oxygen during imagewise exposure; the irradiance and the angularity of the actinic radiation for imagewise exposure; backflash exposure (i.e., exposure through the support to form the floor); and, the reflection of the incident rays of radiation from the support. The creation of different depths of channels and chambers can be determined by conducting a test or tests with a particular photosensitive element having a desired mask image at specific exposure conditions.

In one embodiment of the microfluidic device that is prepared by the present method, a channel and/or chamber can have a relief depth that extends from the uppermost surface of the precursor to the top of the floor; and another channel and/or chamber can have a relief depth that is less (than the depth to the floor), i.e., extends from the uppermost or top surface of the precursor to a position higher than (or above) the top of the floor. For example, an opaque line (in the mask) that is 100 micron wide can create a recessed area in the cured photopolymer layer that extends from an uppermost or top surface of the precursor to the top of the floor; whereas an opaque area that is adjacent to a transparent gap (in the mask) that is 100 microns wide can create a recessed area in the cured photopolymer layer that only extends 50 microns deep (and not to the top of the floor). Additionally, direct imaging provides easy control of the feature widths so that a range of feature depths can be produced in the photopolymerizable layer. For example, the use of direct imaging through a mask can create in the photopolymer layer 100 micron wide channels that connect to chambers having 100 to 500 micron depth.

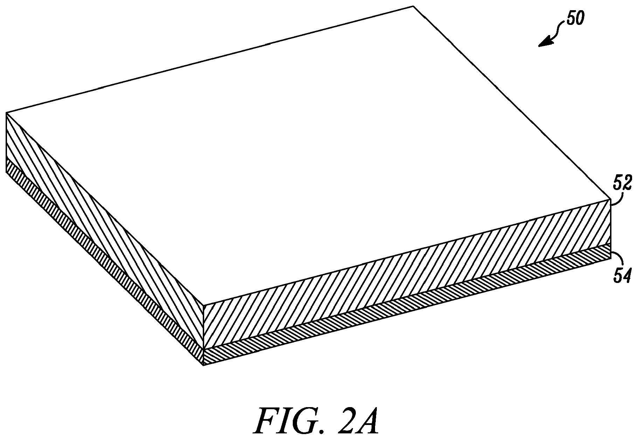

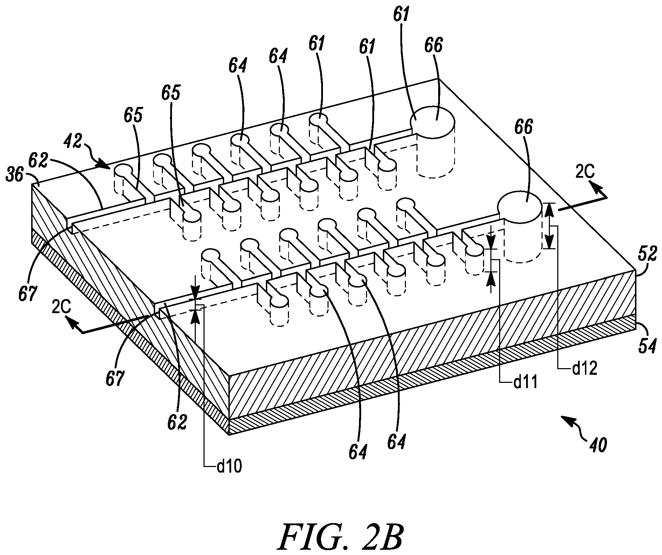

Referring to FIG. 2A through 2C, an example of another embodiment of a microfluidic device prepared according to a method of the present invention is shown. FIG. 2A shows one embodiment of a cover member 50 having polymeric layer 52, that is cured by actinic radiation or by heat, adjacent to a support 54. FIG. 2B shows one embodiment of a microfluidic precursor 40 prepared according to the present method of direct imaging of the photosensitive element 10, preferably as described in FIG. 1A through 1D. In the embodiment shown, the precursor 40 has a relief surface 42 of recessed areas 61 that will form channels 62 that are in communication with chambers 64, 66 for the microfluidic device 55. The precursor 40 has two channels 62, each of which has an end opening 67 to an exterior side surface of the polymeric layer 37 that will allow the fluid to travel through the microfluidic device, and an opposite end connected to the large chamber 66. Each of the channels 62 is in communication with a plurality of smaller chambers 64 via branch channels 65; and, is in communication to the large chamber 66. The use of the terms "large" and "small" in reference to chambers 64, 66 is to differentiate chambers, and can be based upon the depth and/or the volume of the respective chambers. The channels 62, plurality of small chambers 64, and large chambers 66 have different dimensions, especially different depths. The channels 62 have a depth d10 that is from the exterior surface 36 of polymeric layer 37 to a bottom at the cured polymeric layer of the channel 62. The small chambers 64 have a depth d11 that is from the exterior surface 36 of polymeric layer 37 to a bottom at the cured polymeric layer of the small chamber 64. The large chambers 66 have a depth d12 that is from the exterior surface 36 of polymeric layer 37 to a bottom at the cured polymeric layer of the large chamber 66. The depth d10 of channels 62 is shallower than the depth d11 of the small chambers 64; and, the depth d11 of the small chambers 64 are shallower than the depth d12 of the large chambers 66. In this embodiment of the precursor, the recessed areas, i.e., the chambers, of the precursor do not include a reagent.

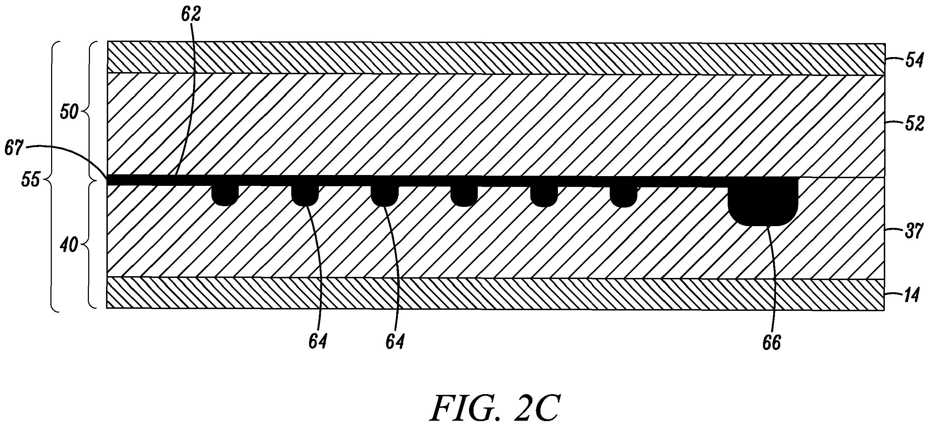

In FIG. 2C, the microfluidic device 55 is formed by the intimate mating of a face surface of the cover member 50 of FIG. 2A and the exterior surface 36, of the relief surface 42 of the microfluidic precursor 40 of FIG. 2B. Intimate contact of the cover member 50 to the exterior surface 36 of the precursor 40 covers the open recessed areas 61 and form an enclosed channel 62 and enclosed chambers 64, 66 of the microfluidic device 55. The microfluidic device 55 has been consumed or used for testing a fluid since the channel 62, plurality of small chambers 64, and the large chamber 64 are filled with a test fluid 70.

The photosensitive element that has been imagewise exposed and treated now includes a relief pattern of microstructures having raised elements and recessed areas, and is referred to as a microfluidic device precursor. The microfluidic device precursor may also be referred to herein as a microfluidic precursor or a precursor. Unlike end-use application of the photosensitive element for printing in which the raised surfaces form the image and are used to transfer ink from the printing form to a printed substrate, for end-use as a microfluidic device the recessed areas or the pattern of recessed areas are essential for transport of testing solutions and/or containment of reagent materials to function as a microfluidic device. Depending upon the end-use application, the microfluidic device will have a pattern of microstructures that includes at least one channel and at least one chamber connected to the at least one channel. The recessed areas of the microfluidic precursor, which will ultimately be the microstructure of channel/s and chamber/s of the microfluidic device, are open (i.e., not enclosed). The recessed areas include sidewalls and bottom.

In some embodiments, one or more of the recessed areas of the precursor, particularly the chambers, include one or more diagnostic reagents to produce an optically detectable signal. The diagnostic reagent can be applied to the chamber and then dried to form a layer coating on the bottom and/or the sidewalls of the chamber. In one embodiment, it is contemplated that a robotic device can be used to apply the diagnostic reagent or reagents to the appropriate recessed areas of the precursor. In another embodiment, it is contemplated that the diagnostic reagent/s can be applied by ink-jetting to the appropriate recessed areas of the precursor. Typically, the chamber or recessed area is not filled by the reagent and leaves sufficient room for the analyte to travel into the chamber and react with the reagent. A microfluidic device can include one or more diagnostic reagents that differ chemically or in concentration or molarity.

In yet other embodiments, no reagent is applied to the recessed areas of the precursor, and once converted to the microfluidic device, a fluid is transported through the channel to chambers to evaluate a rate of change to the fluid. The dimension of each of the chambers created in the device prepared by the present method can be sized and shaped to create ladders that allow for analysis of growth rate of microorganisms, such as bacteria.

The relief pattern can include relief structure that becomes the optional fill enhancing duct/s for the microfluidic device. The fill enhancing duct/s is a recessed path formed in the polymerized layer of the microfluidic device that communicates directly or indirectly (through one or more other duct/s) to at least one chamber, but is not connected directly to a channel or flow channel in the device. The fluid-fill enhancing ducts are not channels in which analyte flows through to the chamber/s. The fluid-fill enhancing ducts are not chambers for evaluation of the reagent or analyte, and do not include a reagent applied to its recessed path. The fluid-fill enhancing ducts are formed in the same manner as microstructure features for the microfluidic device are formed as described above. One example of fluid-fill enhancing ducts are shown in FIG. 4A through FIG. 4C. In some embodiments, the time to degas and fill chamber/s with the analyte fluid for a microfluidic device that is prepared by the present method to have only at least one channel and a chamber (i.e., without fill-enhancing duct/s) can take from about 30 to about 240 minutes. The time to degas a microfluidic device and thereby fill a chamber with analyte can be reduced with the device having one or more of the duct/s connected to the chamber. If one duct is present for a given chamber, one end of the duct directly communicates to the chamber and the opposite end of the duct is not connected to communicate with any other feature of the device. If more than one duct is present for a given chamber, one end of each duct can directly connect to the chamber with the opposite end of the duct not connected to communicate with any other feature of the device. If more than one duct is present for a given chamber, at least one end of one duct directly connects to communicate with the chamber with the remainder of the one duct connected to one or more other ducts and not connected to communicate with any other feature of the device. These other ducts are indirectly connected to the chamber by connecting to the one duct that is directly connected to the chamber. One end of the other duct/s connects at any location along a length of the directly connected duct, or to other duct/s that ultimately connect to the directly connected duct. In general, the fill-enhancing duct/s is near or adjacent to their respective chamber/s, and the plurality of ducts will be distributed in an area surrounding the chamber. In some embodiments, each chamber can be exclusively connected to its own pattern or group of the one or more ducts. In other embodiments, two or more chambers can be connected and share the pattern or group of one or more ducts. The dimension of the fill-enhancing ducts can be the same or different from the dimensions of the chamber to which the duct is connected.

Advantageously in most embodiments, the photosensitive element includes a plurality individual patterns that will form the microstructures for use in a plurality of microfluidic devices. The present method that uses a preformed photosensitive element having a solid photopolymerizable layer and directly images through a mask to form microstructures can easily and rapidly create a plurality of microfluidic devices each with its own custom pattern of microstructures suitable for particular diagnostic purposes. After imagewise exposure and treating to form the relief of microstructures, the element (that is, the microfluidic precursor) having the plurality of patterns for microfluidic devices can be cut according to their microstructure pattern to size/s suitable for use as microfluidic devices, and cover member can be applied for each individual cut-out microfluidic precursor; or, the precursor can remain whole and have a cover member applied thereon prior to cutting to the individual microfluidic devices. The application of the reagent/s to the desired recessed areas can occur while the precursor element remains whole (i.e., prior to cutting) or after the precursor element has been cut into individual microfluidic precursors.

After the cover member is applied to the microfluidic precursor, the microfluidic device is prepared for end-use operation. For the microfluidic device to operate by degas driven flow, air or gas is removed or substantially removed from within the device, with an externally applied vacuum. Degassing is the removal of air or gas from the polymeric material that forms the microfluidic device according to the present invention. Degassing at least removes or evacuates the air or gas from the polymeric layer that forms the precursor, and can remove the air or gas from a cover member, if the cover member is composed of a degassable polymeric material. Degassing also can remove air or gas from the microfeatures, i.e., channels and chambers, of the microfluidic device. In most embodiments degassing is done by placing the device in a sealable enclosure, such as a bag or package, drawing a vacuum to remove air from the microfluidic device and the enclosure, and sealing the enclosure to prevent or minimize air from entering the enclosure and device, and thus gas will dissolve out of the body (i.e., layer) of the polymer comprising the device. The bag or package will maintain the vacuum until the microfluidic device is ready for diagnostic testing. When exposed to air, gas will re-dissolve into the body of the polymer thereby creating a vacuum with the channels and chambers of the device. This vacuum drives the flow of fluid through the microfluidic device.

In most embodiments, at least a portion of the microfluidic device that is designed to communicate with the reagent will reside in the analyte, so that the analyte will be driven by degas flow into the microfluidic device.

### Cover Member

The microfluidic precursor is converted to a microfluidic device by the attachment of a cover member to the side of the precursor having the relief surface, thereby closing or covering the open recessed areas of the relief surface. The cover member can be formed from a layer of any material capable of being degased itself, or that is gas-impermeable. The cover member can be prepared from a photosensitive element, a non-photosensitive element, a self-supporting film, or a thermally-sensitive element.

In some embodiments, the cover member is formed from a photosensitive element that is the same or substantially the same as the photosensitive element forming the microfluidic precursor. Any of the components described for use in the photopolymerizable layer of the photosensitive element forming the microfluidic precursor can also be used for the photosensitive element forming the cover member. However, in most embodiments the cover member does not include a relief surface, and thus is a solid planar layer of the photopolymerizable material that has been cured to have a thickness that is uniform or substantially uniform, i.e., has no induced relief pattern. To form the cover member, at least the front side (i.e., side opposite the support) of the photosensitive element is blanket or overall exposed to actinic radiation without a mask present, for a sufficient time and energy to cure the depth of the thickness of the photopolymerizable layer. The element may also be exposed to actinic radiation through the support to facilitate curing of the thickness of the photopolymerizable layer. In most embodiments, the photosensitive element for use as a cover member need not include any additional layers. In some other embodiments, the cover member can include a relief surface, and can be formed by the same or substantially the same method as described above for the photosensitive element. In some of these other embodiments, the relief pattern of the cover member corresponds, in whole or in part, to the microfeatures formed in the microfluidic precursor. That is, the cover member can include a relief pattern of at least one channel and/or at least one chamber that mates with or complements one or more channels and/or one or more chambers respectively, of the microfluidic precursor.

Yet other embodiments of the cover member include thermally-curable poly(dimethylsiloxane) (PDMS) and photocurable perfluoropolyether (PFPE) materials. Since these materials are typically a liquid and the cover member need not include a relief, it is relatively easy to form a layer of these materials and appropriately cured the layer to a layer of uniform or substantially uniform thickness for use as the cover member for the microfluidic device. Optionally, a cover member can include a support as described above on to which the layer of PDMS or PFPE is formed or applied. Microfluidic devices created from the precursor prepared from the photosensitive element as described above in combination with the cover member of PDMS or PFPE may have additional advantages of increased fill-rate by the analyte or fluid (i.e., reduced time to degas the device and fill the chambers), and provide increased growth of microorganisms, such as bacterial cells.

In some embodiments, the inherent tackiness of the contacting surface of the microfluidic precursor and possibly that of the cover member will facilitate the mating and attachment of the cover member to the uppermost or top surface of the relief pattern of the microfluidic precursor. Alternatively, the contacting surface, i.e., exterior surface, of the microfluidic precursor and/or the contacting surface of the cover member can be treated to promote adhesion between the precursor and the cover member, with flame-treatment or electron-treatment, e.g., corona-treated. The cover member and the precursor can be mated together manually, or with the assistance of a device, such as a laminating device. Optionally, pressure and/or heat can be used to assure intimate contact of the cover member to the precursor. The mating of the precursor to the cover member alone or with lamination may be sufficient to create seal that will avoid air leaks and the ability to remove air from the device. Alternatively, the precursor and cover member can be sufficiently mated, but the process of removing air from the device, i.e., degassing, assures the seal between the precursor and the cover member.

### EXAMPLES

In the following examples, all percentages are by weight unless otherwise noted. CYREL® photopolymerizable printing plate precursors, CYREL® Digital Imager, CYREL® exposure unit, CYREL® processor, and Cylosol washout solution are all available from E.I. DuPont de Nemours, (Wilmington, DE, USA).

### Example 1

The following Example demonstrates one embodiment of a method for preparing degas-driven flow microfluidic device from a photosensitive element having a solid layer of a photopolymerizable composition.

The photosensitive element used was a CYREL® photopolymerizable printing plate precursor, type DPR67. The precursor, which will be referred to herein as a photosensitive element, or simply element, included a support of polyethylene terephthalate, a photopolymerizable layer disposed on the support, a laser-ablatable digital masking layer disposed above the photopolymerizable layer, and a coversheet disposed above the laser-ablatable layer. The total thickness of the photopolymerizable layer and the support was 67 mils (170.2 mm). The photopolymerizable layer includes a triblock copolymer, one more monomers, a photoinitiator, and additives.

The coversheet was removed from the element. The element was mounted on a CYREL® Digital Imager Spark 4260 and an in-situ mask was formed on the element by laser ablation of the black laser-ablatable digital layer with infrared laser radiation. The mask image formed from the digital layer contained lines and images that, once treated, will create a relief pattern. A section of the digital layer of the element was not ablated or removed by laser radiation. The element was exposed on the CYREL® 2000ECLF exposure unit to ultraviolet radiation at 365nm at energy density of 18mW/cm² for an overall exposure through the support for 85 seconds, and for imagewise exposure through the mask in the presence of atmospheric oxygen for seven minutes.

The photosensitive element was treated by processing in a S.W.A.N. 3000P solvent processor, at the conditions recommended for 67 mil (0.17 cm) thick plates, using Cylosol washout solvent at 35.6°C (96°F) temperature. The section of the element with the mask image formed a relief surface having a floor of polymerized material 0.56 mm (22 mils) thick, and a relief pattern in which the lines and images of the mask formed recesses, i.e., open channels and open chambers. The treated element was dried for two hours, and post exposed and finished exposure with 3 minutes UV-A and 5 minutes UV-C to reduce tackiness of the plates. The section of the element that was not imaged formed a smooth, i.e., non-relief surface, having substantially the same thickness as the floor. (The floor is a relatively shallow layer of polymerized material on the support side of the photopolymerizable layer.)

From each of the imaged section and the non-imaged section of the treated element a 3 inch by 4 inch (7.6 cm by 10.2 cm) was cut. The imaged section that was cut out included the relief pattern of channels and chambers. The imaged section was manually mated with the non-imaged section, photopolymeric-face-to-photopolymeric-face, so that the recesses of the open channels and open chambers of the imaged section were covered by the smooth photopolymeric surface of the non-imaged section, and formed closed channels and closed chambers suitable for a microfluidic device (MFD). The support for each section remained intact and sandwiched the facing photopolymeric sections of the microfluidic device (MFD). The MFD was placed in a vacuum bag type Food Saver (from Jarden Corp., Rye, NY, USA), the air was removed from the bag of the mated polymeric layers, and the bag vacuum sealed in a Kenmore Seal-n-Save vacuum sealer (from Sears Roebuck Company, Hoffman Estates, IL, USA). The MFD was kept sealed in the bag under vacuum until use.

For use as a microfluidic device, the MFD was evaluated for its ability to fill the channels and chambers, power-free, and driven by the degassed polymeric layers. The MFD was removed from the vacuum bag and trimmed at one edge to expose the open ends of the channels. Residual tackiness of the polymeric layers was sufficient to maintain the layers in the mated state. The trimmed edge was placed in a dye solution of Bromophenol Blue to aid in visualizing the transport of liquid in the channels and chambers. Migration of liquid into channels was observed within 30 minutes and the chambers were substantially filled after 4 hours by degas driven flow. As a control within the MFD, some channels were trimmed at an end opposite the end that was placed in the dye solution to open the opposite ends and expose the opposite ends to air. No filling was observed in the control channels exposed to air confirming that flow was caused by vacuum generated by gas re-dissolving into the polymer rather than capillary action.

FIG. 3A is a planar view of the composite microfluidic device prepared in Example 1 taken at about 2 hours after immersion in the blue dye solution, wherein the composite microfluidic device contains five independent microfluidic devices, which are designated a, b, c, d, and e, and where each independent microfluidic device has a different size main channel (and branch channels) but the same sizes for the large chamber and small chambers. For each independent microfluidic device, the large chamber at an end of each main channel opposite the immersed end is 5000 micron wide and 470 micron deep; and, the small chambers at an end of each plurality of branch channels is 2000 micron wide and 390 micron deep. The main channel of the microfluidic device "a" is 100 microns wide and 55 microns deep, and is exposed to air via channels on the left side. Lack of fill into the channels and chambers of microfluidic device "a" confirms that flow of the fluid is not due to capillary forces. The main channel of microfluidic devices "b", "c", "d", and "e" are 200, 300, 400, and 500 microns wide respectively with depths of the channel about half the width.

FIG. 3B is a planar view of the composite microfluidic device prepared in Example 1, which is the same view shown in FIG. 3A but taken at about 4 hours after immersion in the blue dye solution. The designations a through e for the microfluidic devices that were described for FIG. 3A, are the same for FIG. 3B.

### Example 2

This Example demonstrates the effect of increasing the effective surface area available for gas re-adsorption on the rate of fill with a grid pattern of fluid-enhancing ducts that is directly or indirectly connected to a chamber but not in direct communication with a liquid-fill channel connecting the chamber.

An imageable pattern of channel and chamber architecture was designed in which a chamber was connected to a liquid fill channel on one side and the opposite side of the chamber was connected to a grid of shallow channels. The intent of the shallow channels was to create a large surface area for gas to re-dissolve into the polymer.

The photosensitive element used was a CYREL® photopolymerizable printing plate precursor, type DPC125. The precursor, which will be referred to herein as a photosensitive element, or simply element, included a support of polyethylene terephthalate, a photopolymerizable layer disposed on the support, a laser-ablatable digital masking layer disposed above the photopolymerizable layer, and a coversheet disposed above the laser-ablatable layer. The total thickness of the photopolymerizable layer and the support was 125 mils (0.32 cm). The photopolymerizable layer includes a triblock copolymer, one more monomers, a photoinitiator, and additives.

As describe in Example 1, the photosensitive element was imaged with infrared laser radiation to form a mask, exposed to ultraviolet radiation, and solvent processed at the conditions recommended for DPC125 mil thick plates, with the exception that the in-situ mask created was the imageable pattern of channel and chamber architecture that included a grid pattern that was directly or indirectly connected to a chamber but not in communication with a liquid-fill channel connecting to a chamber. The DPC element was exposed to ultraviolet radiation UVA through the support for 160 seconds, at energy density between about 16 to 18 mW/cm². After solvent washout to remove unexposed material and drying in oven, the element included open channels and open chambers as shown in FIG. 1E (or FIG. 2B). After drying, the element was not given post-exposure or a finishing exposure, and the exterior surface of the element was tacky to the touch.

Another photosensitive element, a CYREL® photopolymerizable printing plate precursor, type TDR125, was prepared for mating with the imaged element having the open channels and open channels. The TDR precursor included a support of polyethylene terephthalate, a photopolymerizable layer disposed on the support, a release layer on the photopolymerizable layer, and a coversheet disposed above the release layer. The total thickness of the photopolymerizable layer and the support was 125 mils (0.32 cm). The photopolymerizable layer includes a triblock copolymer, one more monomers, a photoinitiator, and additives.

The TDR element was blanket exposed through the support and through the front (side opposite the support) without a mask or image pattern to ultraviolet radiation on the 2000ECLF exposure unit for 160 seconds and 720 seconds, respectively, which cured the photopolymerizable layer and provided a flat, smooth exterior surface opposite the support for mating with the imaged element. The element was non-imaged since no relief surface having channels or chambers was formed. The non-imaged element was exposed and processed as above to provide a flat smooth element for mating with the imaged element. The element was solvent processed and dried as described above to remove the release layer, but was not post-exposed or light finished. The exterior surface of the TDR (i.e., non-imaged) element was tacky to the touch.

The imaged element (DPC) was manually mated with the non-imaged element (TDR), photopolymeric-face-to-photopolymeric-face, so that the recesses of the open channels and open chambers of the imaged element were covered by the smooth photopolymeric surface of the non-imaged element, and formed closed channels and closed chambers suitable for a microfluidic device (MFD). The support for each section remained intact and sandwiched the facing photopolymeric sections of the microfluidic device (MFD). The MFD was placed in a vacuum bag type Food Saver (from Jarden Corp., Rye, NY, USA), the air was removed from the bag of the mated polymeric layers, and the bag vacuum sealed in a Kenmore Seal-n-Save vacuum sealer (from Sears Roebuck Company, Hoffman Estates, IL, USA). The MFD was kept sealed in the bag under vacuum until use.

For use as a microfluidic device, the MFD was evaluated for its ability to fill the channels and chambers, power-free, and driven by the degassed polymeric layers. The MFD included a set of pathways having covered channels for fluid flow connected to covered chambers and covered shallow channels for gas to re-dissolve that were directly or indirectly connected to one or more of the covered chambers but not to the fluid-flow channels; and, a set of pathways having covered channels for fluid flow connected to covered chambers as a Control. The MFD was removed from the vacuum bag and trimmed to expose the channels at one edge of the MFD. Residual tackiness of the polymeric layers was sufficient to maintain the layers in the mated state. The trimmed edge was placed in a dye solution of Bromophenol Blue to aid in visualizing the transport of liquid in the channels and chambers. Since the dye solution is dark in color, as more of the area of each of the chambers becomes darker, the more that the dye solution is filling the chamber.

In each of FIG. 4A through 4C, the same segment of a microfluidic device as prepared in Example 2 is shown in which the Control was the two chambers on the left-hand side of the channel where the two chambers were not connected to fill-enhancing ducts; and the chamber on the right-hand side of the channel was directly or indirectly in communication with fill-enhancing ducts that were not directly communication with the fill channel or branch channel. Comparison of the same segment of the microfluidic device at 1 hour, 2 hours, and 3 hours, shows that the time required to fill a chamber that was directly or indirectly connected to the grid of gas dissolution channels (i.e., fill-enhancing ducts) was substantially reduced compared to chambers of the Control that were not connected to a grid of shallow chambers.

### Example 3

This Example demonstrates increased mating adhesion between contacting surfaces of the prepared elements that are not given finishing exposure and post-exposure. In some embodiments after imaging, solvent processing and drying, the exterior surfaces of the layer of photopolymeric material of both the imaged and non-imaged elements can exhibit considerable tackiness which is typically reduced by brief exposure to UV-A and UV-C radiation.

Several MFDs were prepared from precursors as described above in Example 2 however, after the exposing, solvent processing, and drying, the to-be-mated pairs of imaged and non-imaged elements were prepared differently. For Pexp-MFD Samples, pairs of imaged (125DPC) and non-imaged (125TDR) elements were formed into three MFDs, but the exterior surface of the imaged element that was a relief surface having open channels and open chambers was exposed to UV-A radiation for 240 seconds and UV-C radiation for 420 seconds; and, the exterior surface of the non-imaged element was exposed to UV-A for 240 seconds and to UV-C for 360 seconds, prior to mating the non-imaged element to the imaged element. The exterior surfaces of the non-imaged and imaged elements were slightly tacky to the touch prior to mating. And for NPexp-MFD Samples, other pairs of imaged (125DPC) and non-imaged (125TDR) elements were formed into three other MFDs, but the exterior surface of the non-imaged element and the relief surface of the imaged element were not given any post-exposure (UV-A) or finishing exposure (UV-C) prior to mating. Prior to mating, the exterior surface of the layer of photopolymeric material for both the imaged element and non-imaged element exhibited considerable tackiness (to the touch) prior to mating.

The appropriately exposed pairs of imaged and non-imaged elements were mated face-to-face. One of each of the Pexp-MFD Sample and the NPexp-MFD Sample were placed in each of three separate bags and vacuum sealed as described above. Adhesion of a mated pair at the interface between the imaged element and non-imaged element was tested at three days, three weeks, and three months after sealing by cutting open the vacuum bag and manually pulling to separate the mated material of the particular MFD Sample. It was found that at each age after sealing, the force required to separate the mated faces of the imaged and non-imaged elements forming the NPexp-MFD Sample was dramatically greater than the force required to separate the mated faces of the imaged and non-imaged elements forming the Pexp-MFD Sample.

The MFDs that are prepared to include the step/s of post-exposure and/or light finishing exposure will still retain sufficient tackiness to maintain face-to-face mating of the imaged and non-imaged photopolymeric elements under gentle handling such that the MFD will still function, but it is contemplated that the adhesion between the imaged and non-imaged photopolymeric elements is likely not robust enough to withstand handling during manufacturing and use in the field. It is contemplated that the MFDs that are prepared as described but do not include post-exposure and/or finishing exposure will have sufficient the adhesion between the imaged and non-imaged photopolymeric elements so that the MFDs are robust enough to withstand handling during manufacturing and use in the field.

### Example 4

The following example demonstrates relative gas absorption capacity for polydimethylsiloxane (PDMS) sheet silicone and a solid sheet of an elastomeric photopolymerizable material that is not silicone and is composed of an A-B-A block copolymer as binder, monomer/s, photoinitiator, and other additives.

For Material 4A, 6 grams of solid sheet material of CYREL® photopolymerizable element, type DPC125, was placed in a vacuum chamber at 10⁻² Torr for 3 hours. The Material 4A sample of the solid photopolymerizable element included a base support of polyethylene terephthalate, and the sample was exposed to uv radiation prior to placement in the chamber. The sheet of Material 4A was then removed from vacuum and placed in a sealed test tube to which one end of a 1 ml pipette had been affixed. (The end of the pipette resided in the sealed test tube and did not contact Material 4A.) The free end of the pipette (opposite the end in the test tube) was immersed in dye and the volume of air absorbed by the sheet material was determined by measuring the volume of dye drawn into the pipette. The volume at intervals was recorded and allowed for the determination of rate of microliters of air removed per gram of material. The rate of gas absorption capacity of Material 4A is shown in FIG. 5A.

For Material 4B, 7.79 grams of BISCO HT6240 polydimethylsiloxane (PDMS) polymer sheet (Rogers Corp. (Rogers, CT, USA)) that was 0.062 inch thick was placed in a vacuum chamber at 10⁻² Torr for 3 hours. The sheet of Material 4B was removed from vacuum, placed in a sealed test tube, and the gas absorption rate determined as described above. The rate of gas absorption capacity of Material 4B is shown in FIG. 5B.

As shown in FIG. 5A and FIG. 5B, the Material 4A exhibits about one third the gas absorption rate of Material 4B, respectively. The photopolymerizable material of Material 4A, such as the CYREL photopolymerizable precursor, exhibited the ability to generate vacuum upon re-dissolution of gas into the bulk polymer as shown in FIG. 5A. However, as also shown by the comparison of FIG. 5A to FIG 5B, the rate of re-dissolution is slower of Material 4A than the rate of re-dissolution shown of Material 4B like silicone polymers such as PDMS.

### Example 5

The following example demonstrates the advantages of a hybrid microfluidic device that combines the ease of use of a photopolymerizable printing precursor that can be imagewise exposed to easily produce microfluidic features with a silicone polymer that provides rapid gas absorption.

An image file for a 5.4 inch by 5.65 inch microfluidic device having 10,000 wells was created in Adobe Illustrator and the file transferred to a CYREL® Digital Imager. The photosensitive element used was a CYREL® photopolymerizable printing plate precursor, type DPC125. The precursor, which will be referred to herein as a photosensitive element, or simply element, included a support of polyethylene terephthalate, a photopolymerizable layer disposed on the support, a laser-ablatable masking layer disposed above the photopolymerizable layer, and a coversheet disposed above the laser-ablatable layer. The total thickness of the photopolymerizable layer and the support was 125 mils (3.8 mm). The photopolymerizable layer includes a tri-block A-B-A copolymer, one or more monomers, a photoinitiator, and additives.

The coversheet was removed from the element. The element was mounted on a CYREL® Digital Imager Spark 4260. Using the transferred image file for a microfluidic device having 10,000 wells, an in-situ mask was formed on the element by laser ablation of the black laser-ablatable layer with infrared laser radiation. The mask image formed in the ablatable layer was a reproduction of the image for a microfluidic device having 10,000 wells and contained lines and images that, once the element is treated, will create a relief pattern of the wells, i.e., channels and chambers, etc. The element was exposed on the CYREL® 3000EC exposure unit to ultraviolet radiation at 365nm at energy density of 18 mW/cm² for an overall back exposure through the support for 14 seconds, and for the main imaging exposure through the mask in the presence of atmospheric oxygen for seven minutes.

The photosensitive element was treated with a washout solvent in a S.W.A.N.1000P solvent processor using the deep scrub program #21 set for 0.125 inch plate thickness and 0.106 inch relief with a feed speed of 1.575 inches / min and 35 minute scrub time. The treated element was dried for 3 hours, and post exposed with 3 minutes UV-A to reduce tackiness of the resulting treated element.

From each of the imaged sections, a 5 inch by 6 inch section was cut. The imaged section that was cut out included the relief pattern of channels and chambers. The imaged section was manually mated with a 5 inch by 6 inch section of 0.062 inch thick polydimethylsiloxane (PDMS) polymer sheet (type BISCO HT6240, from Rogers Corp, (Rogers, CT, USA)). To improve adhesion between the PDMS and the CYREL® relief element, the mating surface of both sections were manually corona treated for 30 seconds with a handheld corona surface treater, model BD-20AC, (from Electro-Technic Inc., (Chicago, IL, USA)) prior to mating. After mating the corona-treated surfaces of the sections face-to-face, the hybrid structure that was composed of the section of the relief element and the section of PDMS that is a microfluidic device precursor, was placed in a vacuum chamber and held under a vacuum of 10⁻² Torr for 3 hours to remove gas dissolved within the polymers. Immediately after removal from the vacuum chamber, the microfluidic device (MFD) was placed in a vacuum bag type Food Saver (from Jarden Corp., Rye, NY, USA), and the bag vacuum sealed in a Kenmore Seal-n-Save vacuum sealer (from Sears Roebuck Company, Hoffman Estates, IL, USA). The MFD was kept sealed in the bag under vacuum until use.

The 5 inch by 6 inch hybrid microfluidic device included a relief pattern that was 4.5 inch wide by 5.65 inch high; forming 10,000 wells that were 100 across and 100 down; and a 1.8 ml sample chamber (i.e., loading reservoir) having dimensions of 113 mm x 16 mm x 2 mm. The relief pattern included big channels having nominal widths of 0.5 mm and 0.35 mm; main channels having a nominal width of 0.2 mm, chamber links having nominal width of 0.1 mm; and chambers having nominal width of 0.75 mm.

To demonstrate the functionality of the device, the MFD was removed from the bag and secured in a vertical position in front of a light source used for photography. One milliliter of water containing dark blue dye was added to a loading reservoir and images recorded at regular intervals to document the filling or the device. The device was substantially filled after 15 minutes. FIG. 6A shows filling of the MFD with the blue dye at 30 seconds; and FIG. 6B shows filling of the MFD with the blue dye at 20 minutes.

## Claims

1. A method for preparing a microfluidic device comprising:
a) providing a photosensitive element comprising a solid layer of a photopolymerizable composition comprising a binder, a monomer, and a photoinitiator;
b) imagewise exposing the photopolymerizable layer to actinic radiation through a mask, forming at least a cured portion and an uncured portion of the layer;
c) treating to remove the uncured portion from the layer and thereby form a precursor of the cured portion having an exterior surface and a relief pattern comprising at least one channel that is open to the exterior surface; and,
d) disposing a cover member above the exterior surface of the precursor to enclose the channel and form the microfluidic device; and.
e) degassing the precursor of the microfluidic device of step d) by applying vacuum.

2. The method of Claim 1 wherein the relief pattern comprises the at least one channel and at least one chamber in communication with the at least one channel, wherein the at least one channel has a depth from the exterior surface, and the at least one chamber has a depth from the exterior surface, further wherein the depth of the chamber can be the same or different than the depth of the channel.

3. The method of Claim 1 or Claim 2, wherein the at least one channel communicates with two or more chambers.

4. The method of any one of claims 1 to 3, wherein the photopolymerizable layer is adjacent a support and has a thickness, and wherein prior to the treating step c), the method further comprising exposing the photosensitive element to actinic radiation through the support to form a floor of the photopolymerizable layer that is a cured layer having a thickness that is less than the thickness of the photopolymerizable layer.

5. The method of any one of claims 1 to 4, wherein the photosensitive element further comprises a digital layer that is opaque to actinic radiation and sensitive to laser radiation, and is disposed on or adjacent the solid photopolymerizable layer, the method further comprising imagewise exposing the digital layer to laser radiation prior to step b) to form the mask on or adjacent the solid photopolymerizable layer.

6. The method of any one of claims 1 to 5 wherein the photosensitive element includes a support adjacent the photopolymerizable layer and a top surface that is opposite the support, wherein the imagewise exposing step is selected from
b1) contacting a phototool to the top surface of the photosensitive element, optionally drawing vacuum of the phototool to the photosensitive element and, exposing the photopolymerizable layer to the actinic radiation through the phototool as the mask;
b2) creating a digital mask as the mask by imagewise exposing a digital element to laser radiation, placing the digital mask adjacent the top surface of the element, optionally laminating the digital mask to the photosensitive element, and exposing the photopolymerizable layer to the actinic radiation through the digital mask;
b3) imagewise exposing a digital layer that is disposed on or adjacent to the photopolymerizable layer to laser radiation to selectively remove portions of the digital layer from the photosensitive element, and thereby form an in-situ mask as the mask, and exposing the photopolymerizable layer to the actinic radiation through the in-situ mask;
b4) imagewise exposing a digital layer disposed on an image element that is adjacent to the top surface of the photosensitive element to laser radiation to selectively transfer portions of the digital layer to the photosensitive element, and thereby form a ditial mask as the mask disposed above the photopolymerizable layer, and exposing the photopolymerizable layer to the actinic radiation through the digital mask; or
b5) imagewise applying by ink-jetting an actinic radiation opaque material on or above the photopolymerizable layer to form an ink mask as the mask, and exposing the photopolymerizable layer with the actinic radiation through the ink mask.

7. The method of any one of claims 1 to 6 further comprising forming the cover member by overall exposing a second photosensitive element comprising a solid layer of a photopolymerizable composition comprising a binder, a monomer, and a photoinitiator to actinic radiation to form a cured polymeric layer.

8. A photoimageable microfluidic device precursor element (10) comprising:
a solid layer (12) of a photopolymerizable composition comprising a binder, a monomer, and a photoinitiator, and a digitally imageable element layer having a digital layer (16) disposed above the solid photopolymerizable layer (12), wherein the solid layer (12) is selectively imageable and removable to form at least one channel for transporting a fluid therein.

9. The photoimageable microfluidic device precursor element (10) of Claim 8, wherein the digital layer (16) is opaque to actinic radiation and sensitive to infrared laser radiation.

10. A microfluidic device precursor (40) comprising:
a photocured layer (37) of a photosensitive element comprising a support (14) and a solid layer (12) of a photopolymerizable composition comprising a binder, a monomer, and a photoinitiator adjacent the support (14), the photocured layer (37) having an exterior surface (36) opposite the support (14) and is a channel-bearing layer comprising at least one channel for transport of a fluid, and optionally at least one chamber that communicates with at least one channel, wherein the at least one channel and the optional at least one chamber are open to the exterior surface, and further comprising a cover member (50) disposed in contact with the exterior surface to enclose the at least one channel, wherein the cover member (50) is selected from
a photocured layer of a second photosensitive element comprising a solid layer of a photopolymerizable composition comprising a binder, a monomer, and a photoinitiator; or
a cured layer of a polymeric material selected from polydimethylsiloxanes or perfluoropolyethers.

11. The microfluidic device precursor (40) of Claim 10 wherein the photocured layer (37) further comprises a pattern of one or more fill-enhancing ducts that are directly or indirectly in communication with one of the at least one chambers, but the fill-enhancing ducts are not in direct communication with the at least one channel.

12. The microfluidic device precursor (40) of Claim 10 or claim 11 wherein the exterior surface (36) of the photocured layer and/or a surface of the cover member (50) that mates with the exterior surface is sufficiently tacky to adhere the cover member (50) and photocured layer.

13. A de-gas driven microfluidic device (55) comprising:
a photocured layer (37) of a first photosensitive element comprising a solid layer of photopolymerizable composition comprising a binder, a monomer, and a photoinitiator, the photocured layer (37) having an exterior surface (36) and is a channel-bearing layer comprising at least one channel for transport of a fluid, and optionally at least one chamber that communicates with at least one channel, wherein the at least one channel and the optional at least one chamber are open to the exterior surface (36);
optionally, a diagnostic reagent disposed in the at least one chamber; and,
a cover member (50) disposed in contact with the exterior surface (36) enclosing the at least one channel, and the at least one chamber if present;
wherein the photocured layer (37) is degassed.

14. The de-gas driven microfluidic device (55) of Claim 13 wherein the first photosensitive element further comprises a support (54) adjacent to the solid layer (12) of the photopolymerizable composition and opposite the exterior surface (36).

15. The de-gas driven microfluidic device (55) of Claim 13 or Claim 14 wherein the cover member (50) is selected from
a photocured layer (37) of a second photosensitive element comprising a solid layer (17) of a photopolymerizable composition comprising a binder, a monomer, and a photoinitiator, wherein the photopolymerizable composition of the second photosensitive element can be the same or different than the photopolymerizable composition of the first photosensitive element;
a cured layer of a polymeric material selected from polydimethylsiloxanes or perfluoropolyethers;
glass sheet;
a self-supporting polymeric film selected from polystyrenes, polyethylenes, polypropylenes, polycarbonates, fluoropolymers, polyamides, or polyester;
or combinations thereof.

## Patentansprüche

1. Verfahren zum Herstellen einer mikrofluidischen Vorrichtung, umfassend:
a) Bereitstellen eines fotoempfindlichen Elements, umfassend eine feststoffliche Schicht einer fotopolymerisierbaren Zusammensetzung, umfassend ein Bindemittel, ein Monomer und einen Fotoinitiator;
b) bildweises Exponieren der fotopolymerisierbaren Schicht einer aktinischen Bestrahlung durch eine Maske, wodurch mindestens einen ausgehärteten Abschnitt und einen nicht ausgehärteten Abschnitt der Schicht gebildet werden;
c) Behandeln zum Entfernen des nicht ausgehärteten Abschnitts von der Schicht und dadurch Bilden einer Vorstufe des ausgehärteten Abschnitts mit einer äußeren Oberfläche und einem Reliefmuster, umfassend mindestens einen Kanal, der zu der äußeren Oberfläche geöffnet ist; und
d) Anordnen eines Abdeckungsglieds über der äußeren Oberfläche der Vorstufe, um den Kanal einzuschließen und die mikrofluidische Vorrichtung zu bilden; und
e) Entgasen der Vorstufe der mikrofluidischen Vorrichtung von Schritt d) durch Anwenden eines Vakuums.

2. Verfahren nach Anspruch 1, wobei das Reliefmuster den mindestens einen Kanal und mindestens eine Kammer in Kommunikation mit dem mindestens einen Kanal umfasst, wobei der mindestens eine Kanal eine Tiefe von der äußeren Oberfläche aufweist und die mindestens eine Kammer eine Tiefe von der äußeren Oberfläche aufweist, wobei ferner die Tiefe der Kammer die gleiche wie die Tiefe des Kanals oder davon verschieden sein kann.

3. Verfahren nach Anspruch 1 oder Anspruch 2, wobei der mindestens eine Kanal mit zwei oder mehr Kammern kommuniziert.

4. Verfahren nach einem der Ansprüche 1 bis 3, wobei die fotopolymerisierbare Schicht angrenzend zu einem Träger ist und eine Dicke aufweist und wobei das Verfahren vor dem Behandlungsschritt c) ferner umfasst, das fotoempfindliche Element einer aktinischen Strahlung durch den Träger zu exponieren, um einen Boden der fotopolymerisierbaren Schicht zu bilden, die eine ausgehärtete Schicht mit einer Dicke ist, die geringer ist als die Dicke der fotopolymerisierbaren Schicht.

5. Verfahren nach einem der Ansprüche 1 bis 4, wobei das fotoempfindliche Element ferner eine digitale Schicht umfasst, die für aktinische Strahlung undurchlässig und gegenüber Laserstrahlung empfindlich ist und auf oder angrenzend an der feststofflichen fotopolymerisierbaren Schicht angeordnet ist, das Verfahren ferner umfassend bildweises Exponieren der digitalen Schicht einer Laserstrahlung vor dem Schritt b), um die Maske auf oder angrenzend an der feststofflichen fotopolymerisierbaren Schicht zu bilden.

6. Verfahren nach einem der Ansprüche 1 bis 5, wobei das fotoempfindliche Element einen Träger angrenzend an der fotopolymerisierbaren Schicht und eine obere Oberfläche, die dem Träger entgegengesetzt ist, enthält, wobei der Schritt des bildweisen Exponierens ausgewählt ist aus
b1) Kontaktieren eines Fotowerkzeugs mit der oberen Oberfläche des fotoempfindlichen Elements, wahlweise Ziehen des Vakuums des Fotowerkzeugs zu dem fotoempfindlichen Element und Exponieren der fotopolymerisierbaren Schicht der aktinischen Strahlung durch das Fotowerkzeug als die Maske;
b2) Erzeugen einer digitalen Maske als die Maske durch bildweises Exponieren eines digitalen Elements einer Laserstrahlung, Platzieren der digitalen Maske angrenzend an der oberen Oberfläche des Elements, wahlweise Laminieren der digitalen Maske an das fotoempfindliche Element und Exponieren der fotopolymerisierbaren Schicht der aktinischen Strahlung durch die digitale Maske;
b3) bildweises Exponieren einer digitalen Schicht, die auf oder angrenzend an der fotopolymerisierbaren Schicht angeordnet ist, einer Laserstrahlung, um selektiv Abschnitte der digitalen Schicht von dem fotoempfindlichen Element zu entfernen und dadurch eine In-situ-Maske als die Maske zu bilden, und Exponieren der fotopolymerisierbaren Schicht der aktinischen Strahlung durch die In-situ-Maske;
b4) bildweises Exponieren einer digitalen Schicht, angeordnet auf einem Bildelement, das angrenzend an der oberen Oberfläche des fotoempfindlichen Elements ist, einer Laserstrahlung, um selektiv Abschnitte der digitalen Schicht zu dem fotoempfindlichen Element zu transferieren und dadurch eine digitale Maske als die Maske zu bilden, angeordnet über der fotopolymerisierbaren Schicht, und Exponieren der fotopolymerisierbaren Schicht der aktinischen Strahlung durch die digitale Maske; oder
b5) bildweises Anwenden, durch Tintenstrahlung, eines für aktinische Bestrahlung undurchlässigen Materials auf oder über der fotopolymerisierbaren Schicht, um eine Tintenmaske als die Maske zu bilden, und Exponieren der fotopolymerisierbaren Schicht der aktinischen Strahlung durch die Tintenmaske.

7. Verfahren nach einem der Ansprüche 1 bis 6, ferner umfassend das Bilden des Abdeckungsglieds durch gesamtes Exponieren eines zweiten fotoempfindlichen Elements, umfassend eine feststoffliche Schicht einer fotopolymerisierbaren Zusammensetzung, umfassend ein Bindemittel, ein Monomer und einen Fotoinitiator, einer aktinischen Strahlung, um eine ausgehärtete polymere Schicht zu bilden.

8. Vorstufenelement einer fotostrukturierbaren mikrofluidischen Vorrichtung (10), umfassend:
eine feststoffliche Schicht (12) einer fotopolymerisierbaren Zusammensetzung, umfassend ein Bindemittel, ein Monomer und einen Fotoinitiator, und eine digital strukturierbare Elementschicht mit einer über der feststofflichen fotopolymerisierbaren Schicht (12) angeordneten digitalen Schicht (16), wobei die feststoffliche Schicht (12) selektiv strukturierbar und entfernbar ist, um mindestens einen Kanal zum Transportieren eines Fluids darin zu bilden.

9. Vorstufenelement einer fotostrukturierbaren mikrofluidischen Vorrichtung (10) nach Anspruch 8, wobei die digitale Schicht (16) für aktinische Strahlung undurchlässig und gegenüber Infrarotlaserstrahlung empfindlich ist.

10. Vorstufe einer mikrofluidischen Vorrichtung (40), umfassend:
eine fotoausgehärtete Schicht (37) eines fotoempfindlichen Elements, umfassend einen Träger (14) und eine feststoffliche Schicht (12) einer fotopolymerisierbaren Zusammensetzung, umfassend ein Bindemittel, ein Monomer und einen Fotoinitiator angrenzend an dem Träger (14), wobei die fotoausgehärtete Schicht (37) eine äußere Oberfläche (36) gegenüber dem Träger (14) aufweist und eine Kanal tragende Schicht ist, umfassend mindestens einen Kanal zum Transportieren eines Fluids, und wahlweise mindestens eine Kammer, die mit mindestens einem Kanal kommuniziert, wobei der mindestens eine Kanal und die wahlweise mindestens eine Kammer zu der äußeren Oberfläche geöffnet sind, und ferner umfassend ein Abdeckungsglied (50), angeordnet in Kontakt mit der äußeren Oberfläche, um den mindestens einen Kanal einzuschließen, wobei das Abdeckungsglied (50) ausgewählt ist aus
einer fotoausgehärteten Schicht eines zweiten fotoempfindlichen Elements, umfassend eine feststoffliche Schicht einer fotopolymerisierbaren Zusammensetzung, umfassend ein Bindemittel, ein Monomer und einen Fotoinitiator; oder
einer ausgehärteten Schicht eines polymeren Materials, ausgewählt aus Polydimethylsiloxanen oder Perfluopolyethern.

11. Vorstufe einer mikrofluidischen Vorrichtung (40) nach Anspruch 10, wobei die fotoausgehärtete Schicht (37) ferner ein Muster eines oder mehrerer füllungsverbessernder Gänge umfasst, die mit einer der mindestens einen Kammer direkt oder indirekt in Kommunikation stehen, wobei aber die füllungsverbessernde Gänge mit dem mindestens einen Kanal nicht in direkter Kommunikation stehen.

12. Vorstufe einer mikrofluidischen Vorrichtung (40) nach Anspruch 10 oder Anspruch 11, wobei die äußere Oberfläche (36) der fotoausgehärteten Schicht und/oder eine Oberfläche des Abdeckungsglieds (50), die mit der äußeren Oberfläche übereinstimmt, ausreichend klebrig ist, um das Abdeckungsglied (50) und die fotoausgehärtete Schicht zu verkleben.

13. Entgasungsgetriebene mikrofluidische Vorrichtung (55), umfassend:
eine fotoausgehärtete Schicht (37) eines ersten fotoempfindlichen Elements, umfassend eine feststoffliche Schicht einer fotopolymerisierbarer Zusammensetzung, umfassend ein Bindemittel, ein Monomer und einen Fotoinitiator, wobei die fotoausgehärtete Schicht (37) eine äußere Oberfläche (36) aufweist und eine Kanal tragende Schicht ist, umfassend mindestens einen Kanal zum Transportieren eines Fluids, und wahlweise mindestens eine Kammer, die mit mindestens einem Kanal kommuniziert, wobei der mindestens eine Kanal und die wahlweise mindestens eine Kammer zu der äußeren Oberfläche (36) geöffnet sind;
wahlweise ein diagnostisches Reagens, angeordnet in der mindestens einen Kammer; und
ein Abdeckungsglied (50), angeordnet in Kontakt mit der äußeren Oberfläche (36), das den mindestens einen Kanal und die mindestens eine Kammer, wenn vorhanden, einschließt;
wobei die fotoausgehärtete Schicht (37) entgast ist.

14. Entgasungsgetriebene mikrofluidische Vorrichtung (55) nach Anspruch 13, wobei das erste fotoempfindliche Element ferner einen Träger (54) angrenzend an der feststofflichen Schicht (12) der fotopolymerisierbaren Zusammensetzung und entgegengesetzt zu der äußeren Oberfläche (36) umfasst.

15. Entgasungsgetriebene mikrofluidische Vorrichtung (55) nach Anspruch 13 oder Anspruch 14, wobei das Abdeckungselement (50) ausgewählt ist aus
einer fotoausgehärteten Schicht (37) eines zweiten fotoempfindlichen Elements, umfassend eine feststoffliche Schicht (17) einer fotopolymerisierbaren Zusammensetzung, umfassend ein Bindemittel, ein Monomer und einen Fotoinitiator, wobei die fotopolymerisierbare Zusammensetzung des zweiten fotoempfindlichen Elements die gleiche wie die fotopolymerisierbare Zusammensetzung des ersten fotoempfindlichen Elements oder davon verschieden sein kann;
einer ausgehärteten Schicht eines polymeren Materials, ausgewählt aus Polydimethylsiloxanen oder Perfluopolyethern;
einer Glastafel;
einem selbsttragenden polymeren Film, ausgewählt aus Polystyrenen, Polyethylenen, Polypropylenen, Polycarbonaten, Fluorpolymeren, Polyamiden oder Polyester;
oder Kombinationen davon.

## Revendications

1. Procédé permettant de préparer un dispositif microfluidique, comprenant les étapes consistant à :
a) fournir un élément photosensible comprenant une couche solide d'une composition photopolymérisable comprenant un liant, un monomère, et un photo-initiateur ;
b) exposer à la manière d'une image la couche photopolymérisable à un rayonnement actinique à travers un masque, ce qui forme au moins une partie durcie et une partie non durcie de la couche ;
c) traiter de manière à retirer de la couche la partie non durcie et à former ainsi un précurseur de la partie durcie présentant une surface extérieure et un motif en relief comprenant au moins un canal qui est ouvert vers la surface extérieure ; et
d) agencer un élément formant couverture au-dessus de la surface extérieure du précurseur afin d'enfermer le canal et de former le dispositif microfluidique ; et
e) dégazer le précurseur du dispositif microfluidique de l'étape d) grâce à une étape consistant à appliquer un vide.

2. Procédé selon la revendication 1, dans lequel le motif en relief comprend le au moins un canal et au moins une chambre en communication avec le au moins un canal, dans lequel le au moins un canal présente une profondeur par rapport à la surface extérieure, et la au moins une chambre présente une profondeur par rapport à la surface extérieure, et en outre dans lequel la profondeur de la chambre peut être identique à, ou différente de, la profondeur du canal.

3. Procédé selon la revendication 1 ou la revendication 2, dans lequel le au moins un canal communique avec deux ou plus de deux chambres.

4. Procédé selon l'une quelconque des revendications 1 à 3, dans lequel la couche photopolymérisable est adjacente à un support et présente une épaisseur, et dans lequel, préalablement à l'étape de traitement c), le procédé comprend en outre une étape consistant à exposer l'élément photosensible à un rayonnement actinique à travers le support afin de former un fond de la couche photopolymérisable qui est une couche durcie présentant une épaisseur inférieure à l'épaisseur de la couche photopolymérisable.

5. Procédé selon l'une quelconque des revendications 1 à 4, dans lequel l'élément photosensible comprend en outre une couche numérique qui est opaque au rayonnement actinique et sensible au rayonnement laser, et est agencé sur ou à proximité adjacente de la couche photopolymérisable solide, le procédé comprenant en outre une étape consistant à exposer à la manière d'une image la couche numérique à un rayonnement laser préalablement à l'étape b) afin de former le masque sur ou à proximité adjacente de la couche photopolymérisable solide.

6. Procédé selon l'une quelconque des revendications 1 à 5, dans lequel l'élément photosensible comprend un support adjacent à la couche photopolymérisable et une surface supérieure qui se trouve à l'opposé du support, dans lequel l'étape consistant à exposer à la manière d'une image est sélectionnée parmi les étapes consistant à
b1) mettre en contact un outil photographique avec la surface supérieure de l'élément photosensible, optionnellement faire le vide entre le masque photographique et l'élément photosensible, et exposer la couche photopolymérisable au rayonnement actinique à travers le masque photographique faisant office de masque ;
b2) créer un masque numérique faisant office de masque grâce à une étape consistant à exposer à la manière d'une image un élément numérique à un rayonnement laser, placer le masque numérique à proximité adjacente de la surface supérieure de l'élément, optionnellement plaquer le masque numérique sur l'élément photosensible, et exposer la couche photopolymérisable au rayonnement actinique à travers le masque numérique ;
b3) exposer à la manière d'une image une couche numérique qui est agencée sur ou à proximité adjacente de la couche photopolymérisable au rayonnement laser afin de retirer de l'élément photosensible des parties de la couche numérique de manière sélective, et former ainsi un masque *in situ* faisant office de masque, et exposer la couche photopolymérisable au rayonnement actinique à travers le masque *in situ* ;
b4) exposer à la manière d'une image une couche numérique, agencée sur un élément d'image qui est adjacent à la surface supérieure de l'élément photosensible, au rayonnement laser afin de transférer de manière sélective des parties de la couche numérique vers l'élément photosensible, et former ainsi un masque numérique faisant office de masque agencé au-dessus de la couche photopolymérisable, et exposer la couche photopolymérisable au rayonnement actinique à travers le masque numérique ; ou
b5) appliquer par jet d'encre à la manière d'une image un matériau opaque au rayonnement actinique sur ou au-dessus de la couche photopolymérisable afin de former un masque d'encre faisant office de masque, et exposer la couche photopolymérisable au rayonnement actinique à travers le masque d'encre.

7. Procédé selon l'une quelconque des revendications 1 à 6, comprenant en outre une étape consistant à former l'élément formant couverture en exposant complètement un deuxième élément photosensible comprenant une couche solide d'une composition photopolymérisable comprenant un liant, un monomère, et un photo-initiateur à un rayonnement actinique afin de former une couche polymère durcie.

8. Élément précurseur de dispositif microfluidique dont l'image peut être créée grâce à un procédé photographique (10), comprenant :
une couche solide (12) d'une composition photopolymérisable comprenant un liant, un monomère, et un photo-initiateur, et une couche d'élément dont l'image peut être créée de manière numérique et présentant une couche numérique (16) agencée au-dessus de la couche photopolymérisable solide (12), dans lequel l'image de la couche solide (12) peut être créée de manière sélective et la couche solide peut être retirée afin de former au moins un canal permettant de transporter un fluide en son sein.

9. Élément précurseur de dispositif microfluidique dont l'image peut être créée grâce à un procédé photographique (10) selon la revendication 8, dans lequel la couche numérique (16) est opaque au rayonnement actinique et sensible au rayonnement laser infrarouge.

10. Précurseur de dispositif microfluidique (40), comprenant :
une couche photodurcie (37) d'un élément photosensible comprenant un support (14) et une couche solide (12) d'une composition photopolymérisable comprenant un liant, un monomère, et un photo-initiateur adjacent au support (14), la couche photodurcie (37) présentant une surface extérieure (36) à l'opposé du support (14) et étant une couche porteuse de canal comprenant au moins un canal permettant le transport d'un fluide, et optionnellement au moins une chambre qui communique avec au moins un canal, dans lequel le au moins un canal et l'optionnelle au moins une chambre sont ouverts vers la surface extérieure, et comprenant en outre un élément formant couverture (50) agencé en contact avec la surface extérieure afin d'enfermer le au moins un canal, dans lequel l'élément formant couverture (50) est sélectionné parmi
une couche photodurcie d'un deuxième élément photosensible comprenant une couche solide d'une composition photopolymérisable comprenant un liant, un monomère, et un photo-initiateur ; ou
une couche durcie d'un matériau polymère sélectionné parmi des polydiméthylsiloxanes ou des perfluoropolyethers.

11. Précurseur de dispositif microfluidique (40) selon la revendication 10, dans lequel la couche photodurcie (37) comprend en outre un motif d'un ou de plusieurs conduits améliorant le remplissage qui sont directement ou indirectement en communication avec une parmi la au moins une chambre, mais les conduits améliorant le remplissage ne sont pas en communication directe avec le au moins un canal.

12. Précurseur de dispositif microfluidique (40) selon la revendication 10 ou la revendication 11, dans lequel la surface extérieure (36) de la couche photodurcie et/ou une surface de l'élément formant couverture (50) qui s'apparie avec la surface extérieure est suffisamment collante pour faire adhérer l'élément formant couverture (50) et la couche photodurcie.

13. Dispositif microfluidique à entrainement basé sur le dégazage (55), comprenant :
une couche photodurcie (37) d'un premier élément photosensible comprenant une couche solide de composition photopolymérisable comprenant un liant, un monomère, et un photo-initiateur, la couche photodurcie (37) présentant une surface extérieure (36) et étant une couche porteuse de canal comprenant au moins un canal permettant le transport d'un fluide, et optionnellement au moins une chambre qui communique avec au moins un canal, dans lequel le au moins un canal et l'optionnelle au moins une chambre sont ouverts vers la surface extérieure (36) ;
optionnellement, un réactif de diagnostic agencé dans la au moins une chambre ; et
un élément formant couverture (50) agencé en contact avec la surface extérieure (36) et enfermant le au moins un canal, et la au moins une chambre si elle est présente ;
dans lequel la couche photodurcie (37) est dégazée.

14. Dispositif microfluidique à entrainement basé sur le dégazage (55) selon la revendication 13, dans lequel le premier élément photosensible comprend en outre un support (54) adjacent à la couche solide (12) de la composition photopolymérisable et situé à l'opposé de la surface extérieure (36).

15. Dispositif microfluidique à entrainement basé sur le dégazage (55) selon la revendication 13 ou la revendication 14, dans lequel l'élément formant couverture (50) est sélectionné parmi
une couche photodurcie (37) d'un deuxième élément photosensible comprenant une couche solide (17) d'une composition photopolymérisable comprenant un liant, un monomère, et un photo-initiateur, dans lequel la composition photopolymérisable du deuxième élément photosensible peut être identique à, ou différente de, la composition photopolymérisable du premier élément photosensible ;
une couche durcie d'un matériau polymère sélectionné parmi des polydiméthylsiloxanes ou des perfluoropolyethers ;
une feuille de verre ;
un film polymère autoportant sélectionné parmi des polystyrènes, des polyéthylènes, des polypropylènes, des polycarbonates, des fluoropolymères, des polyamides, ou du polyester ;
ou des combinaisons de ceux-ci.
